# EUROPEAN PATENT APPLICATION

(11) **EP 2 275 458 A1**
(43) Date of publication of application: **19.01.2011**
(21) Application number: 09734343.8
(22) Date of filing: 23.04.2009
(51) Int. Cl.: C08F 12/32, H01L 51/50

(54) **CHARGE-TRANSPORTING POLYMER COMPOUND AND ORGANIC ELECTROLUMINESCENT DEVICE USING THE SAME**

(30) Priority: 24.04.2008 JP 2008113905
(71) Applicant: Showa Denko K.K., Tokyo 105-8518 (JP)
(72) Inventor: KATOH, Tsuyoshi, Chiba-shi Chiba 267-0056 (JP); IGARASHI, Takeshi, Chiba-shi Chiba 267-0056 (JP)
(74) Representative: Fischer, Heinrich
(86) International application number: PCT/JP2009/058043
(87) International publication number: WO 2009/131165

(57) **Abstract**

[Object] The present invention provides a charge-transporting polymer compound capable of giving a high light-emitting efficiency and high luminance, and provides, when such a charge-transporting polymer compound is used in an organic layer, organic EL elements having a low driving voltage.

[Means for solving] The charge-transporting polymer compound of the present invention is **characterized by** comprising a constituting unit derived from at least one polymerizable compound of plural polymerizable compounds each having a specific structure.

## Description

### TECHNICAL FIELD

The present invention relates to a charge-transporting polymer compound containing one heterocyclic ring selected from the group consisting of a pyridine ring, a pyrimidine ring and a pyrazine ring. More specifically, the present invention relates to a charge-transporting polymer compound containing one charge-transporting heterocyclic ring selected from the group consisting of a pyridine ring, a pyrimidine ring and a pyrazine ring which compound is suitably used for organic electroluminescence elements (hereinafter optionally referred to organic EL elements).

### TECHNICAL BACKGROUND

An electroluminescence element using an organic thin film, namely, organic EL element usually has, on a substrate, an anode, a cathode and an organic layer at least containing a light-emitting layer formed between the anode and cathode. In addition to the light-emitting layer, a positive hole-injecting layer (anode buffer layer), a positive hole-transporting layer, a positive hole-blocking layer, an electron-transporting layer, an electron-injecting layer and the like are formed as the organic layer. In general, these layers are laminated between an anode and a cathode to form an organic EL element.

Patent document 1 discloses, as a charge-transporting material used for phosphorescent organic EL elements, an organic compound having a pyridine ring, a pyrazine ring, a pyrimidine ring or a triazine ring as a skeleton and plural carbazolyl groups as a substituent. Such an organic compound is used without polymerization, has both of positive hole-transporting properties and electron-transporting properties and is sometimes referred to "the organic compound having charge-transporting properties".

Patent document 2 discloses a composition for organic EL elements capable of driving at a low voltage which composition comprises a phosphorescent material, an ion radical and a charge-transporting material.

### Citation List

### Patent documents

Patent document 1: JP-A-2006-188493
Patent document 2: JP-A-2007-100083

### SUMMARY OF THE INVENTION

### SUBJECT TO BE SOLVED IN THE PRESENT INVENTION

However, in the organic EL element obtainable by using the organic compound as described in Patent document 1 and the organic EL element obtainable by using the organic EL element composition as described in Patent document 2, there are room for improvement on luminance and luminous efficient.

Under the circumstances, it is an object of the present invention to provide a charge-transporting polymer compound capable of attaining high light-emitting efficiency and high luminance, and to provide organic EL elements having low driving voltage when using the charge-transporting polymer compound as an organic layer of the organic EL elements.

### MEANS FOR SOLVING THE SUBJECT

The present inventors have been studied earnestly in order to solve the above subjects and found that when a charge-transporting polymer compound, which comprises a constituting unit derived from a specific polymerizable compound, is used as an organic layer of organic EL elements, the organic EL elements have low driving voltage and also high light-emitting efficiency and high luminance. Thus, the present invention has been accomplished.

That is to say, the present invention relates to the following characteristics [1] to [9].
[1] A charge-transporting polymer compound comprising a constituting unit derived from at least one polymerizable compound selected from the group consisting of a polymerizable compound represented by the following formula (1), a polymerizable compound represented by the following formula (2) and a polymerizable compound represented by the following formula (3).

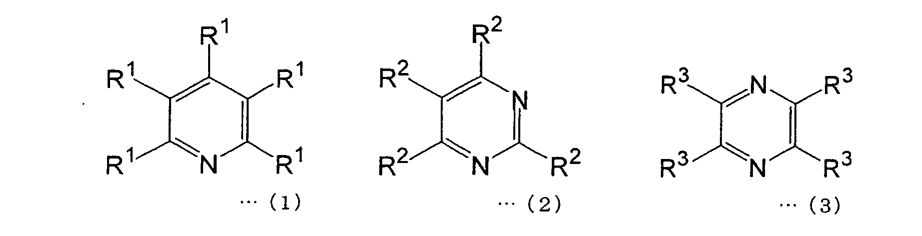

(In the formulas, R¹ to R³ are each independently hydrogen atom or an aromatic group optionally having a heteroatom as a ring-constituting atom; provided that at least one R¹, at least one R² and at least one R³ each represent an aromatic group having a substituent with a polymerizable functional group and optionally having a heteroatom as a ring-constituting atom.)
[2] The charge-transporting polymer compound according to [1] wherein the polymerizable compound of the formula (1) is a polymerizable compound represented by the following formula (4), the polymerizable compound of the formula (2) is a polymerizable compound represented by the following formula (5) and the polymerizable compound of the formula (3) is a polymerizable compound represented by the following formula (6).

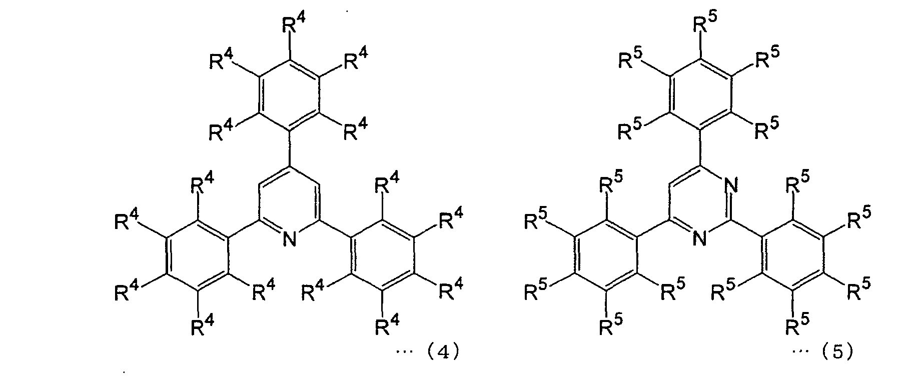

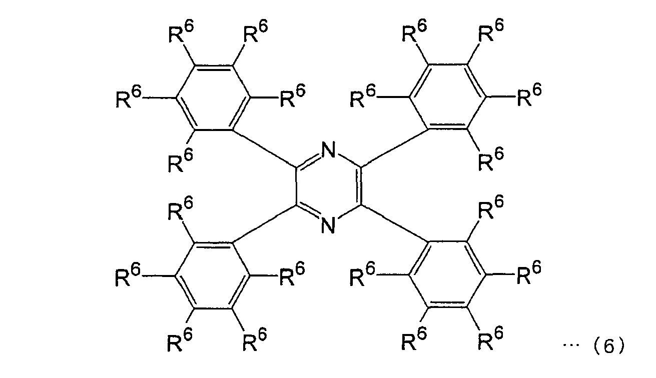

(In the formulas, R⁴ to R⁶ are each independently hydrogen atom, a halogen atom, an alkyl group having 1 to 12 carbon atoms or an aromatic group optionally having a heteroatom as a ring-constituting atom; provided that at least one R⁴, at least one R⁵ and at least one R⁶ each represent an aromatic group having a substituent with a polymerizable functional group and optionally having a heteroatom as a ring-constituting atom.)
[3] The charge-transporting polymer compound according to [2], wherein the polymerizable compound of the formula (4) is a polymerizable compound represented by any one of the following formulas (1-1) to (1-16), the polymerizable compound of the formula (5) is a polymerizable compound represented by any one of the following formulas (2-1) to (2-26) and the polymerizable compound of the formula (6) is a polymerizable compound represented by any one of the following formulas (3-1) to (3-7).

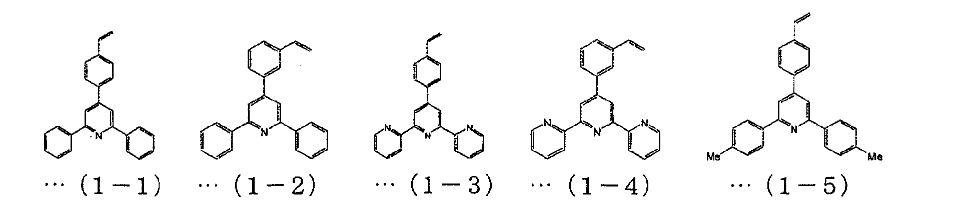

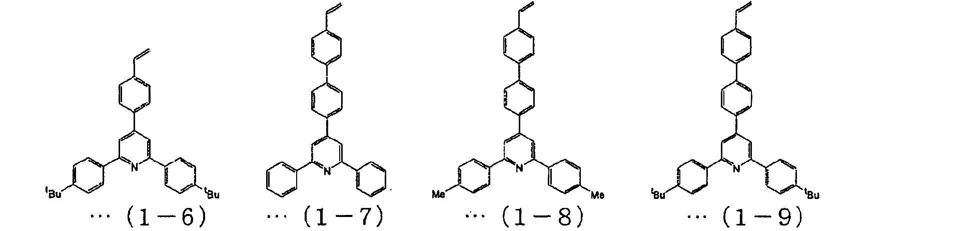

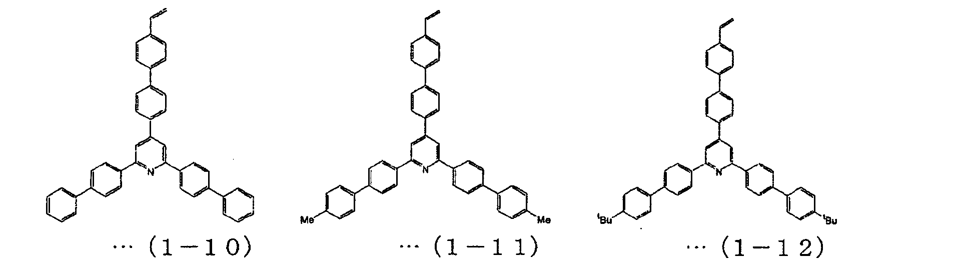

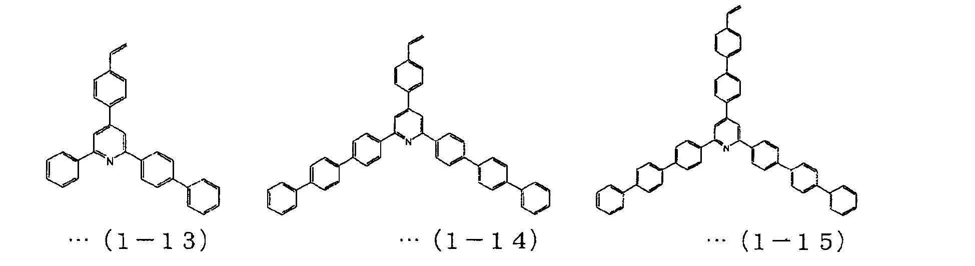

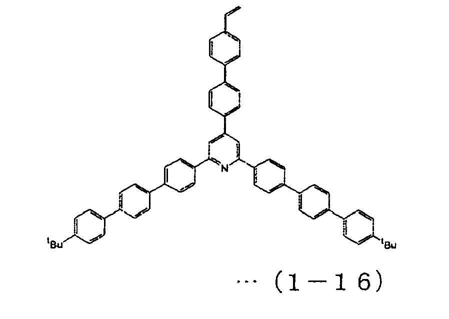

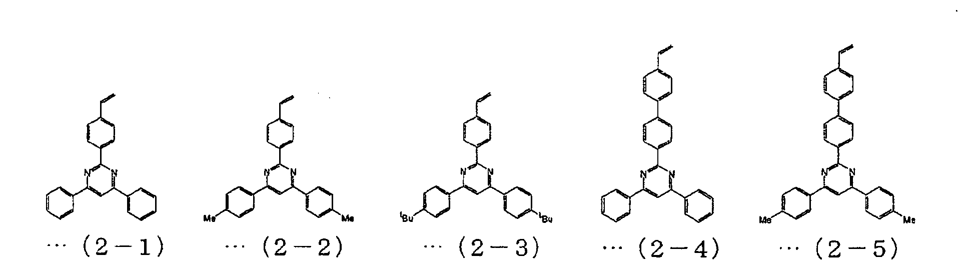

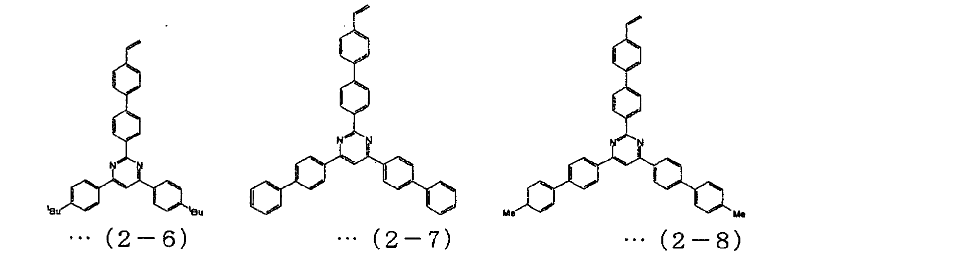

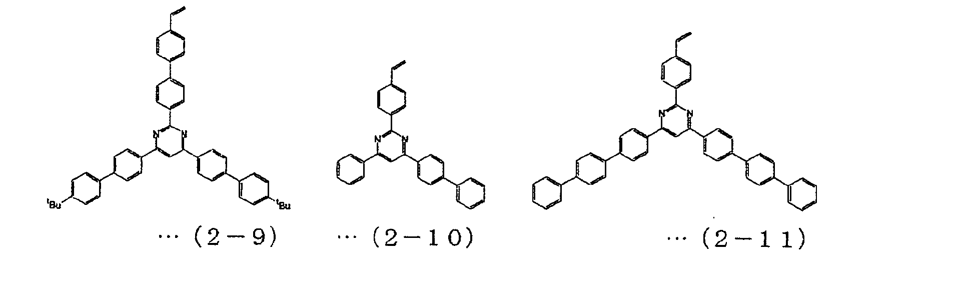

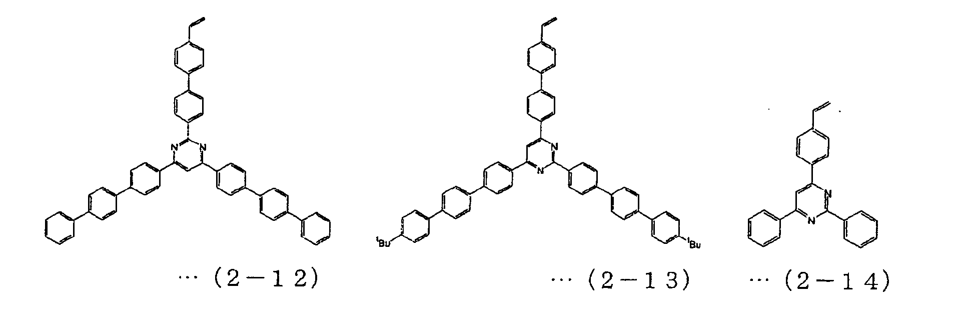

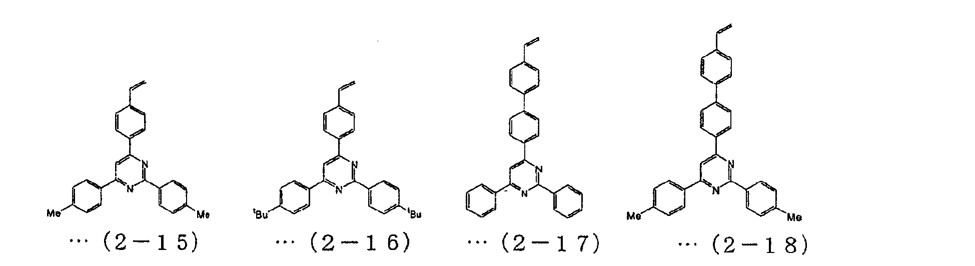

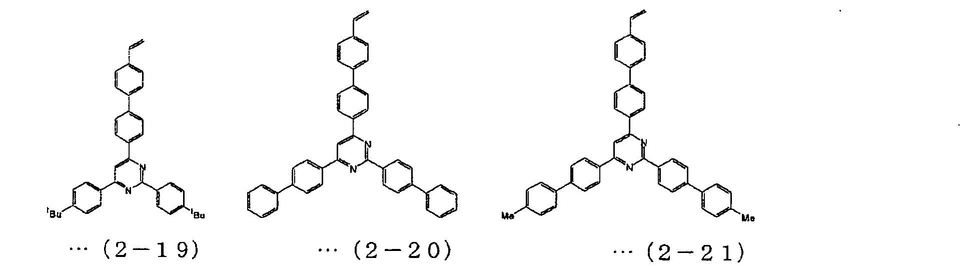

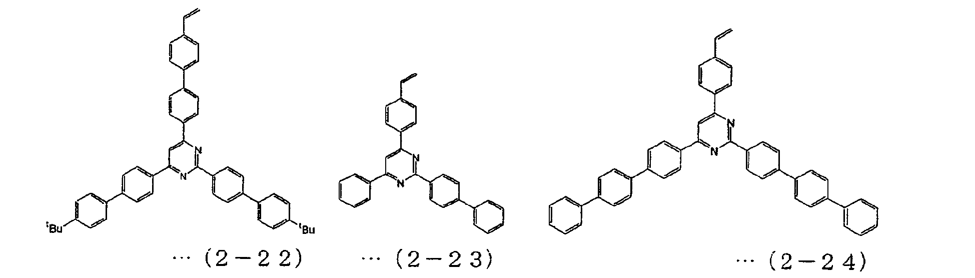

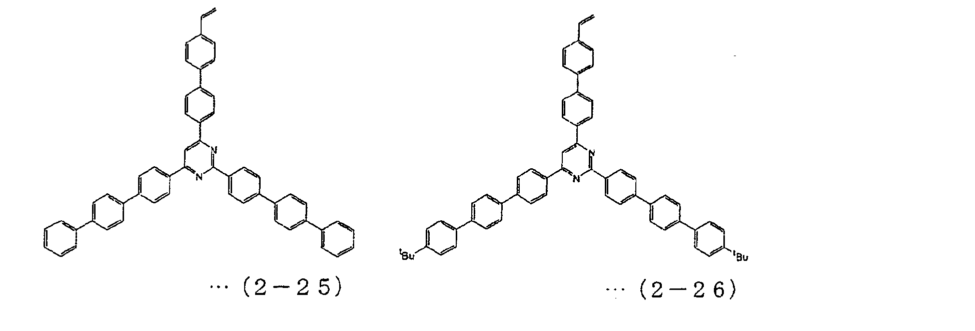

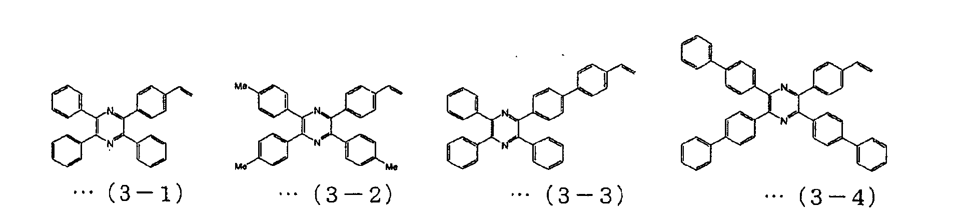

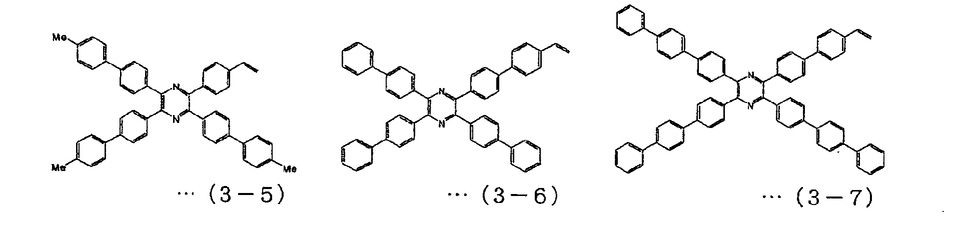

(In the formulas, "Me" is a methyl group and "^{t}Bu" is a t-butyl group.)
[4] The charge-transporting polymer compound according to any one of [1] to [3], which compound further comprises a constituting unit derived from a light-emitting polymerizable compound.

[5] The charge-transporting polymer compound according to [4], wherein the light-emitting polymerizable compound has phosphorescent properties.
[6] The charge-transporting polymer compound according to [5], wherein the light-emitting polymerizable compound is a transition metal complex having a substituent with a polymerizable functional group.

[7] The charge-transporting polymer compound according to [6], wherein the transition metal complex is an iridium complex.
[8] The charge-transporting polymer compound according to any one of [1] to [7], which compound further comprises a unit derived from a polymerizable compound having positive hole-transporting properties.

[9] An organic electroluminescence element formed with a light-emitting layer between an anode and a cathode, wherein the light-emitting layer comprises the charge-transporting polymer compound according to any one of [1] to [8].

### EFFECT OF THE INVENTION

The use of the charge-transporting polymer compound according to the present invention can prepare organic EL elements having low driving voltage, high light-emitting efficiency and high luminance.

### BRIEF DESCRIPTION OF THE DRAWING

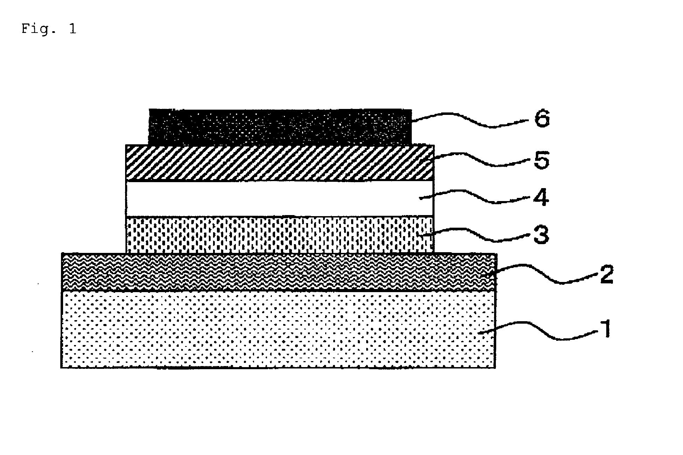

Fig. 1 is a sectional view showing an example of the organic EL element of the present invention.

### PREFERRED EMBODIMENT FOR CARRYING OUT THE INVENTION

The present invention will be described in detail hereinafter. In the present specification, electron-transporting properties and positive hole-transporting properties are inclusively referred to "charge-transporting properties" or "carrier-transporting properties".

### <Embodiment 1>

The polymer compound (I) of the present invention (Embodiment 1) comprises a constituting unit derived from at least one polymerizable compound having charge-transporting properties selected from those represented by the above formulas (1) to (3), preferably (4) to (6), more preferably (1-1) to (3-7), and is obtainable by polymerizing at least one polymerizable compound having charge-transporting properties selected from those represented by the above formulas (1) to (3), preferably (4) to (6), more preferably (1-1) to (3-7).

In the formulas (1) to (3), R¹ to R³ are each independently hydrogen atom or an aromatic group optionally having a heteroatom as a ring-constituting atom; provided that at least one R¹, at least one R² and at least one R³ each represent an aromatic group having a substituent with a polymerizable functional group and optionally having a heteroatom as a ring-constituting atom.

Examples of the aromatic group are a phenyl group, a biphenylyl group, a terphenylyl group, a pyridyl group and a pyrimidyl group.
In the formulas (4) to (6), R⁴ to R⁶ are each independently hydrogen atom, a halogen atom, an alkyl group having 1 to 12 carbon atoms or an aromatic group optionally having a heteroatom as a ring-constituting atom, provided that at least one R⁴, at least one R⁵ and at least one R⁶ each represent an aromatic group having a substituent with a polymerizable functional group and optionally having a heteroatom as a ring-constituting atom.

Examples of the halogen atom are a fluorine atom, a chlorine atom, a bromine atom and an iodine atom.
Examples of the alkyl group having 1 to 12 carbon atoms are methyl group, ethyl group, propyl group, isopropyl group, butyl group, isobutyl group, t-butyl group, amyl group, hexyl group, octyl group, decyl group, 2-ethylhexyl group and dodecyl group.

In the formulas (4) to (6), examples of the aromatic group are phenyl group, biphenylyl group, pyridyl group and pyrimidyl group.
The polymerizable functional group may be any one of radical polymerizable, cation polymerizable, anion polymerizable, addition polymerizable and condensation polymerizable functional groups. Of these groups, the radical polymerizable functional group is preferred because the polymer production is easy. Specifically, substituents represented by the formula (7) are preferred as the substituent having a polymerizable functional group.

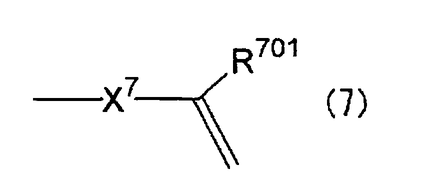

In the formula (7), R⁷⁰¹ is hydrogen or an alkyl group having 1 to 12 carbon atoms.

Examples of the alkyl group having 1 to 12 carbon atoms may include methyl group, ethyl group, propyl group, isopropyl group, butyl group, isobutyl group, t-butyl group, amyl group, hexyl group, octyl group, decyl group, 2-ethylhexyl group and dodecyl group. Of these, R⁷⁰¹ is preferably hydrogen because of having excellent carrier-transporting properties.

In the formula (7), X⁷ is a single bond or a group represented by any one of the formulas (X71) to (X74).

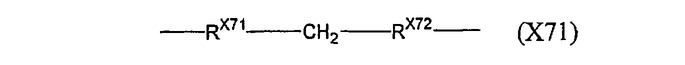

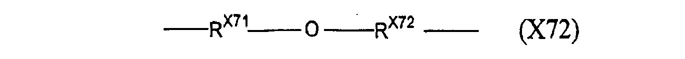

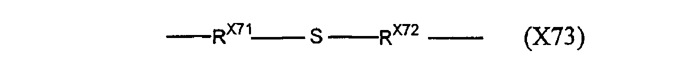

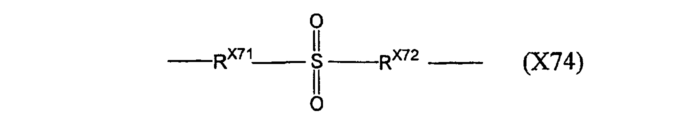

In the formulas, R^{X71} is a single bond or an alkylene group having 1 to 12 carbon atoms, and R^{X72} is a single bond, an alkylene group having 1 to 12 carbon atoms or a phenylene group.
Examples of the alkylene group having 1 to 12 carbon atoms may include methylene group, ethylene group, trimethylene group, tetraethylene group, octaethylene group, decaethylene group and dodecaethylene group.

In the formulas (X71) to (X74), R^{X71} preferably bonds to an aromatic group and R^{X72} preferably bonds to a vinyl group. According to such X⁷_{,} it is possible to prepare organic EL elements having low driving voltage, high light-emitting efficiency and high luminance.
Of these, X⁷ is preferably a single bond or an alkylene group having 1 to 20 carbon atoms, more preferably a single bond. As described above, when X⁷ dose not contain a heteroatom, it is possible to prepare organic EL elements having higher light-emitting efficiency.

In the formulas (1) to (6), R¹ to R⁶ may have each a substituent other than the substituent having a polymerizable functional group. Examples of such a substituent are a cyano group, an amyl group, an alkyl group having 1 to 12 carbon atoms and an alkoxy group having 1 to 12 carbon atoms.

Examples of the alkyl group having 1 to 12 carbon atoms may include methyl group, ethyl group, propyl group, isopropyl group butyl group, isobutyl group, t-butyl group, amyl group, hexyl group, octyl group, decyl group, 2-ethylhexyl group and dodecyl group.

Examples of the alkoxy group having 1 to 12 carbon atoms may include methoxy group, ethoxy group, propoxy group, isopropoxy group, butoxy group, isobutoxy group, t-butoxy group, hexyloxy group, 2-ethylhexyloxy group, decyloxy group and dodecyloxy group.

Preferable examples of the polymerizable compound having charge-transporting properties are polymerizable compounds represented by the following formulas (1-1) to (3-7) because the polymerizable compound has excellent solubility and excellent carrier-transporting ability, the synthesis of the polymerizable compound is easy and thereby the polymerizable compound has a symmetric structure. In the formulas, "Me" represents methyl group and "^{t}Bu" represents t-butyl group.

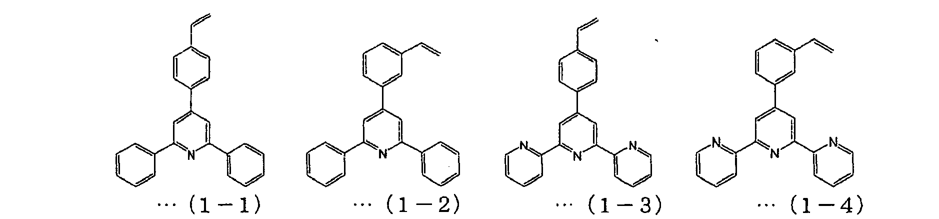

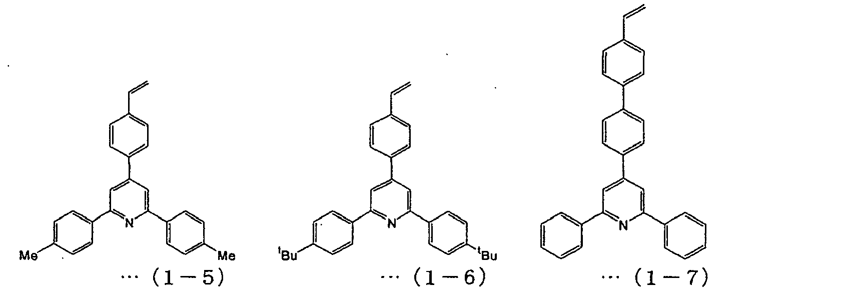

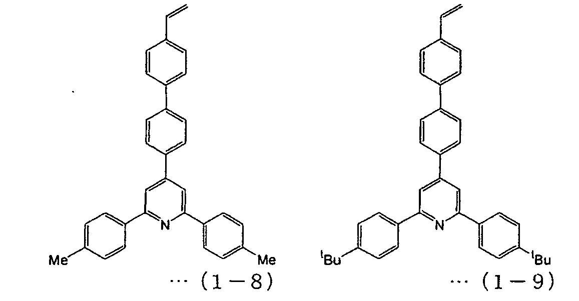

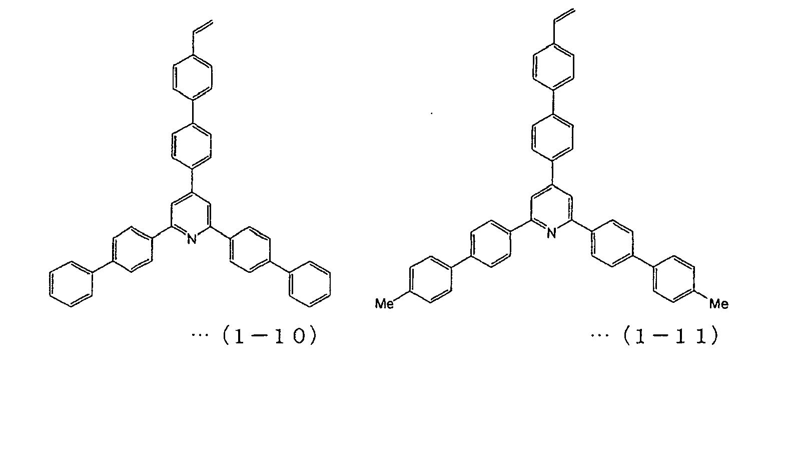

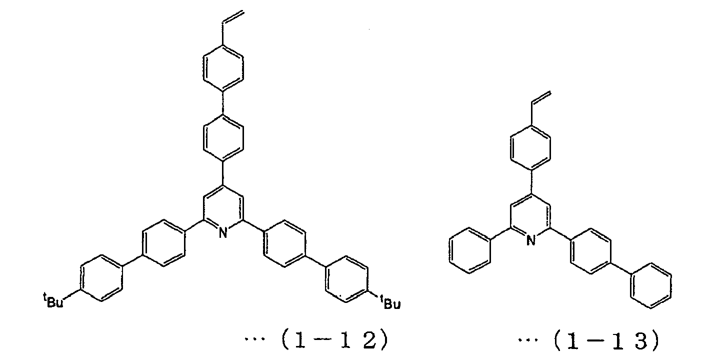

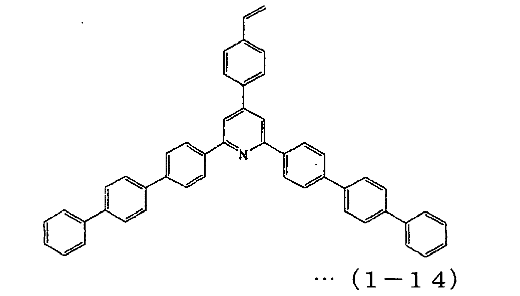

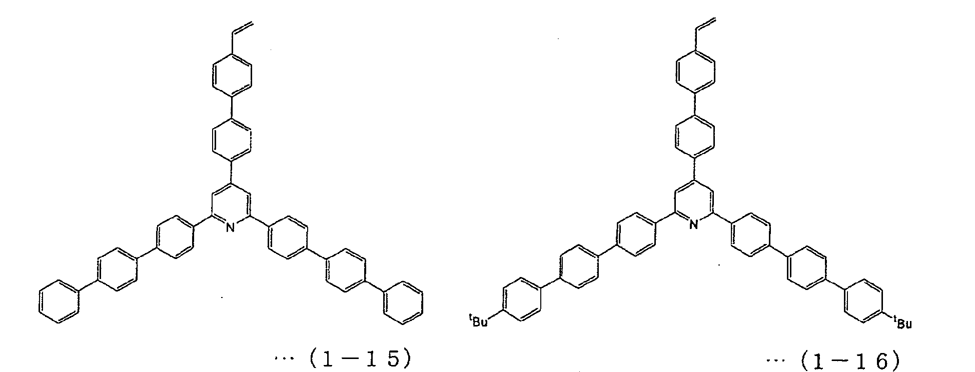

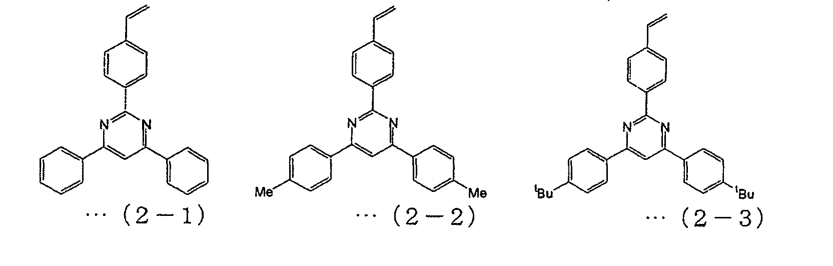

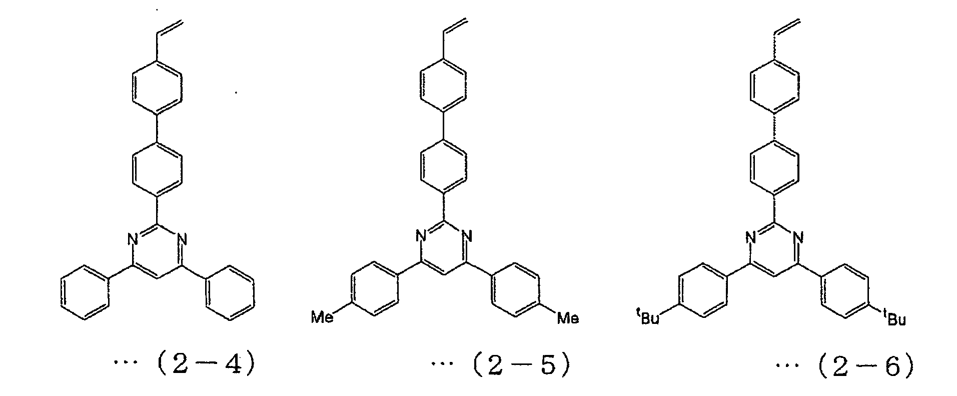

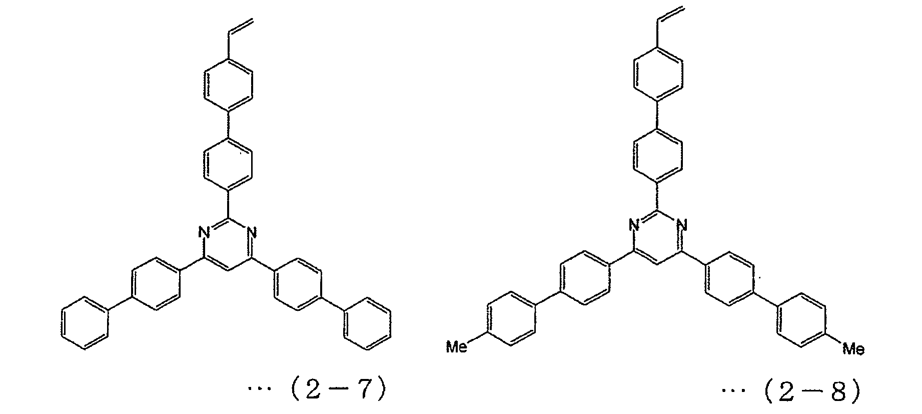

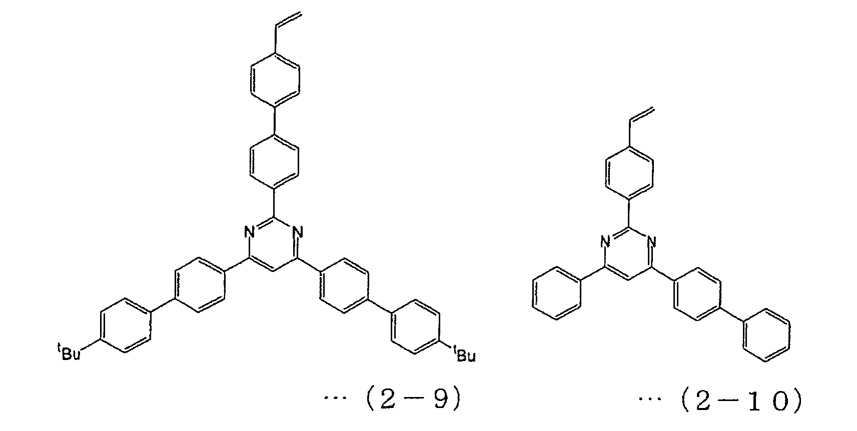

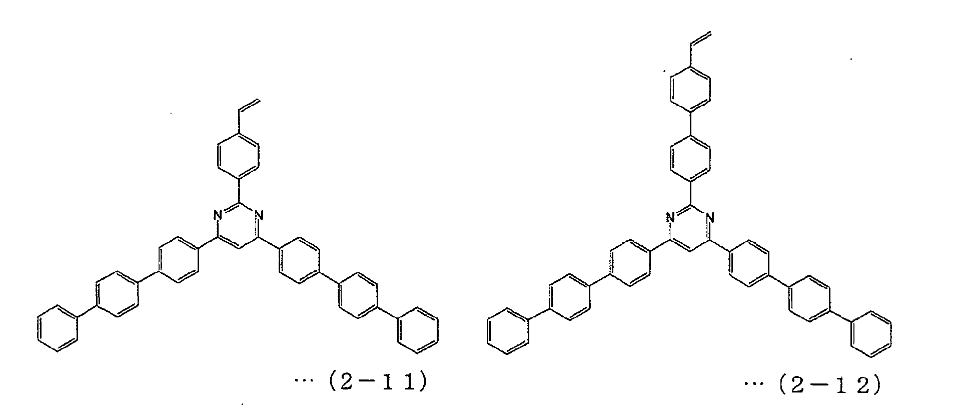

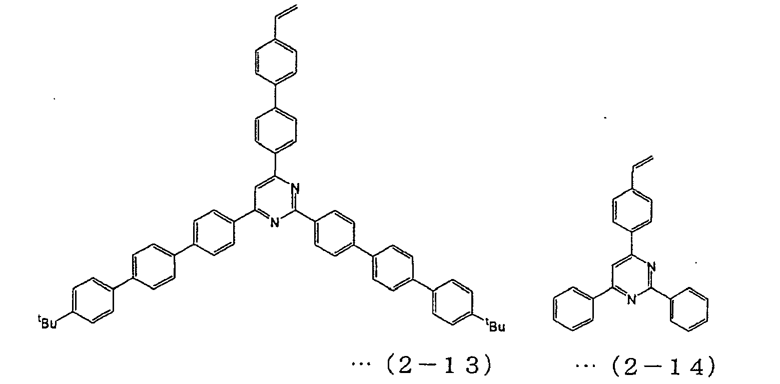

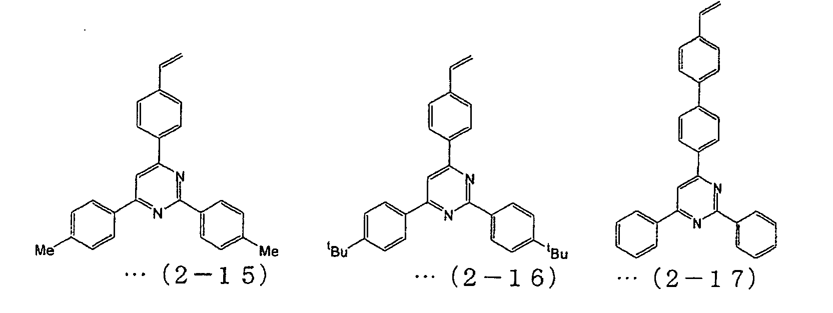

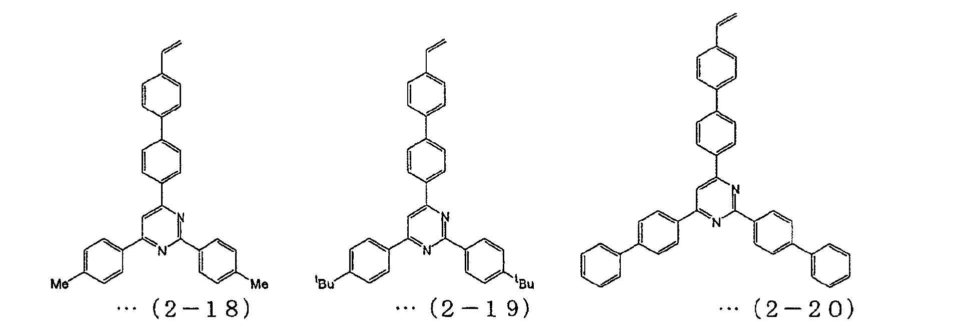

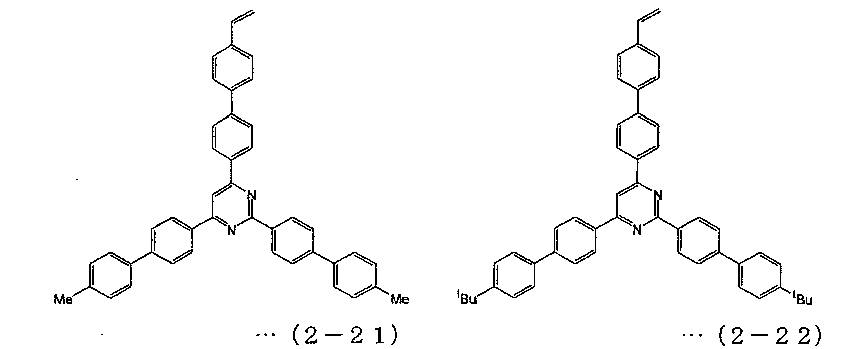

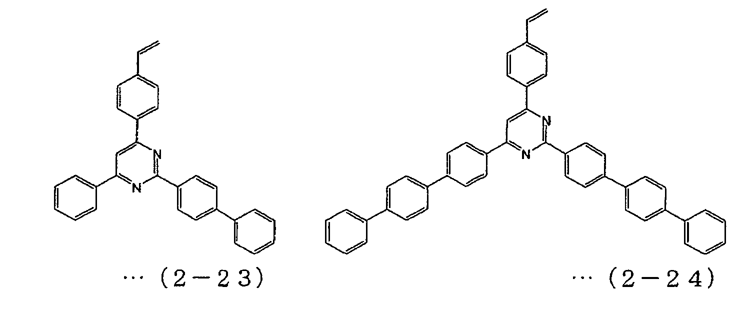

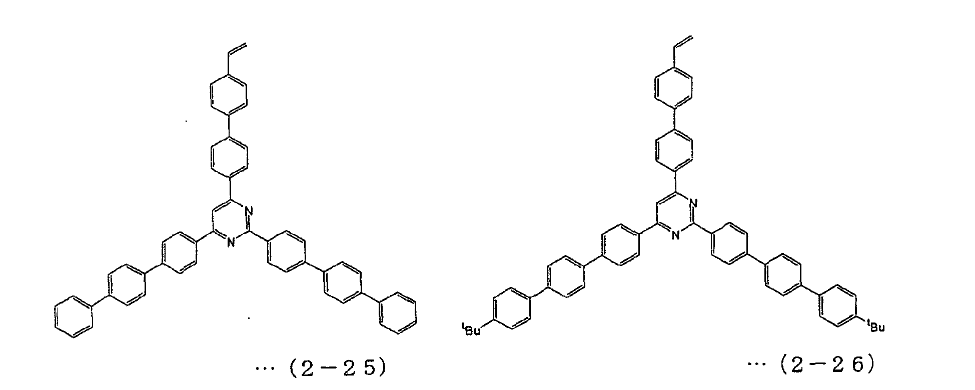

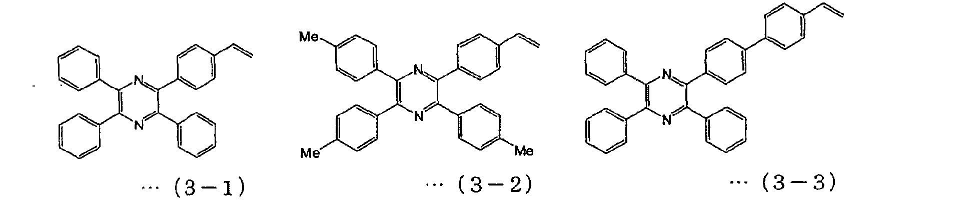

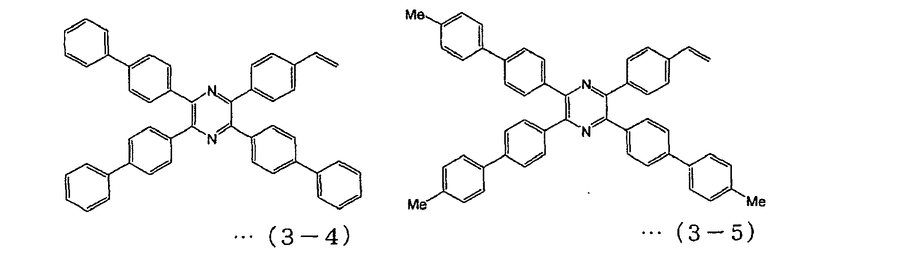

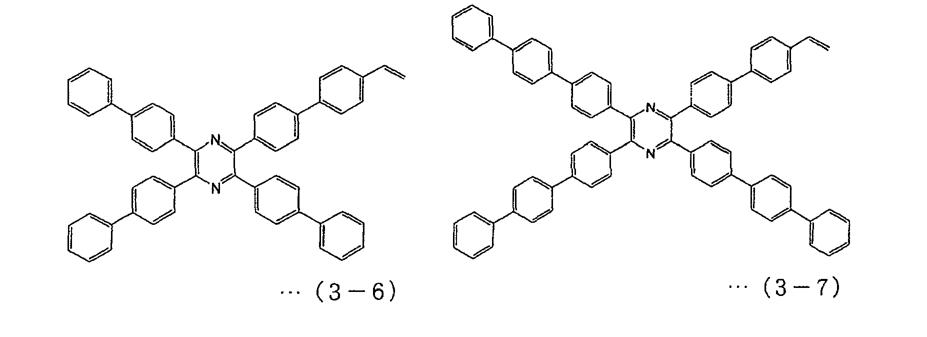

The polymerizable compound having charge-transporting properties represented by any one of the formulas (1) to (3), preferably the formulas (4) to (6), more preferably (1-1) to (3-7) may be used singly or two or more may be combined for use.

The polymerizable compounds having carrier-transporting properties can be prepared by cyclizing an acetophenone derivative with a bromobenzealdehyde using Lewis acid and thereafter coupling with Suzuki coupling method.

The production of the polymer compound (I) may be carried out using the above polymerizable compounds by any one of radical polymerization, cation polymerization, anion polymerization and addition polymerization and it is carried out preferably by radical polymerization.

In producing the polymer compound (I), other polymerizable compounds may be used. Non-limiting examples of the polymerizable compounds are compounds having no carrier-transporting properties, for example, (meth) acrylic acid alkyl esters such as methyl acrylate, methyl methacrylate and the like, styrene and derivatives thereof.

The polymer compound (I) has a weight average molecular weight of preferably 1,000 to 2,000,000, more preferably 5,000 to 500,000. The polymer compound (I) preferably has a weight average molecular weight in the above range because it is soluble in an organic solvent and can prepare a uniform thin film. The weight average molecular weight is a value determined by using tetrahydrofuran as a solvent at 40°C with the gel permeation chromatography (GPC) method.

With respect to the solubility of the polymer compound (I) in an organic solvent such as toluene, chloroform, etc, 1 part by mass of the polymer compound (I) is dissolved in preferably 0.1 to 200 parts by mass, more preferably 1 to 50 parts by mass of the organic solvent. The solubility thereof is preferably in the above range because organic EL elements are easily prepared by the coating method.

### <Embodiment 2>

The polymer compound (II) of the present invention (Embodiment 2) comprises a constituting unit derived from at least one polymerizable compound having charge-transporting properties selected from those represented by the above formulas (1) to (3), preferably the formulas (4) to (6), more preferably the formulas (1-1) to (3-7), and a constituting unit derived from a polymerizable compound having light-emitting properties. The polymer compound (II) is obtainable by polymerizing at least one polymerizable compound having charge-transporting properties selected from those represented by the formulas (1) to (3), preferably the formulas (4) to (6), more preferably the formulas (1-1) to (3-7), and the polymerizable compound having light-emitting properties.

The polymerizable compound having charge-transporting properties represented by at least one of the above formulas (1) to (3), preferably the formulas (4) to (6), more preferably the formulas (1-1) to (3-7) has the same meanings as those of the polymerizable compound having charge-transporting properties used in the embodiment 1 and the preferred reasons thereof are similar to the embodiment 1.

The polymerizable compound having light-emitting properties preferably has phosphorescent properties, is more preferably a transition metal complex having a substituent with a polymerizable functional group, furthermore preferably an iridium complex having a substituent with a polymerizable functional group.

Preferable examples of the iridium complex used are complexes represented by the following formulas (8) to (10). These polymerizable compounds have a vinyl group, which is a polymerizable functional group.

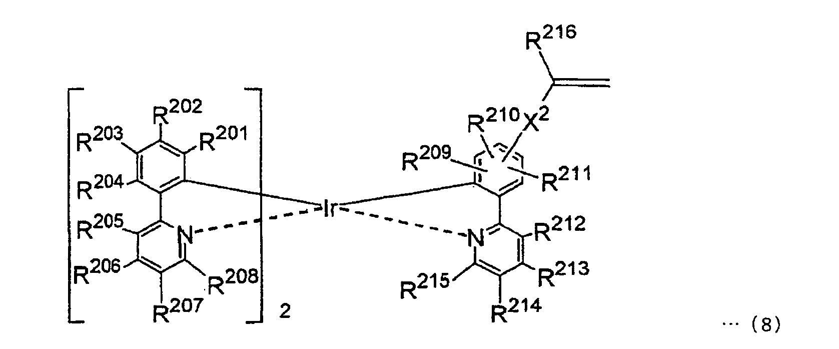

In the formula (8), R²⁰¹ to R²¹⁵ are each independently an atom or a substituent selected from the group consisting of hydrogen atom, a halogen atom, a cyano group, an alkyl group having 1 to 10 carbon atoms, an aryl group having 6 to 10 carbon atoms, an amino group optionally substituted with an alkyl group having 1 to 10 carbon atoms, an alkoxy group having 1 to 10 carbon atoms and a silyl group.

Examples of the halogen atom are a fluorine atom, a chlorine atom, a boron atom and an iodine atom.
Examples of the alkyl group having 1 to 10 carbon atoms are methyl group, ethyl group, propyl group, isopropyl group, butyl group, isobutyl group, t-butyl group, amyl group, hexyl group, octyl group and decyl group.

Examples of the aryl group having 6 to 10 carbon atoms are phenyl group, tolyl group, xylyl group, mesityl group and naphthyl group.
Examples of the amino groups optionally substituted with an alkyl group having 1 to 10 carbon atoms are amino group, dimethylamino group, diethylamino group and dibutylamino group.

Examples of the alkoxy group having 1 to 10 carbon atoms are methoxy group, ethoxy group, propoxy group, isopropoxy group, butoxy group, isobutoxy group, t-butoxy group, hexyloxy group, 2-ethylhexyloxy group and decyloxy group.

Examples of the silyl group are trimethyl silyl group, triethyl silyl group, t-butyl dimethyl silyl group and trimethoxy silyl group.
Of these, because the phosphorescent properties of the polymerizable compound are excellent, R²⁰¹ to R²¹⁵ are each preferably hydrogen atom, a fluorine atom, cyano group, methyl group, t-butyl group, dimethylamino group, butoxy group or 2-ethyl hexyloxy group, more preferably R²⁰² is t-butyl group and R²⁰¹ to R²¹⁵ excluding R²⁰² are each hydrogen atom.

In each ring of R²⁰¹ to R²⁰⁴, R²⁰⁵ to R²⁰⁸, R²⁰⁹ to R²¹¹ and R²¹² to R²¹⁵, two groups, which are adjacent through two carbon atoms, may bond each other to form a condensed ring.

R²¹⁶ is hydrogen atom or an alkyl group having 1 to 12 carbon atoms. Examples of the alkyl group having 1 to 12 carbon atoms are the above-described alkyl groups. Of these, R²¹⁶ is preferably hydrogen atom because the carrier-transporting properties of the polymerizable compound are excellent.

X² is a single bond or a group represented by any of the following formulas (X21) to (X24).

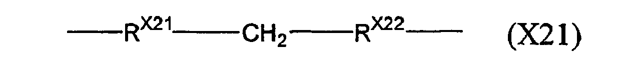

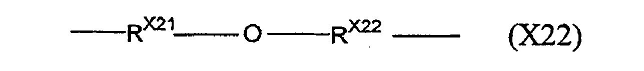

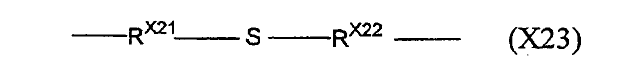

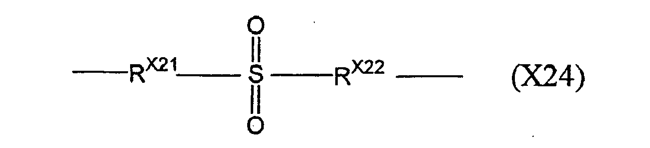

In the formulas, R^{X21} is a single bond or an alkylene having 1 to 12 carbon atoms, R^{X22} is a single bond, an alkylene having 1 to 12 carbon atoms or a phenylene group. In the formula (8), R^{X21} preferably bonds to a benzene ring and R^{X22} preferably bonds to a vinyl group. When X² does not contain a heteroatom, organic EL elements having higher light-emitting efficiency can be prepared.

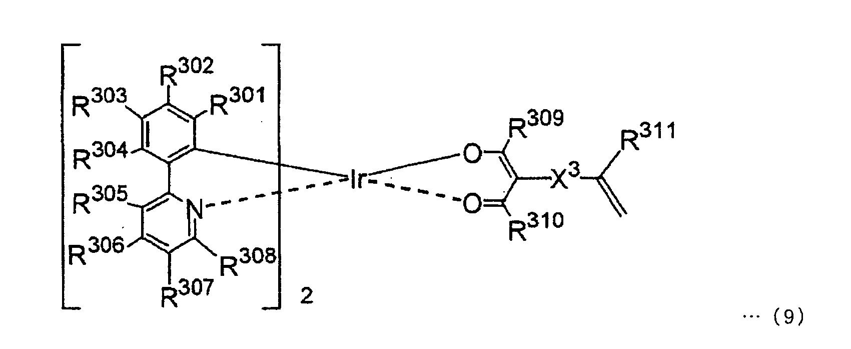

In the formula (9), R³⁰¹ to R³⁰⁸ are each independently the same atom or substituent as those of R²⁰¹.
R³⁰⁹ to R³¹⁰ are each independently the same atom or substituent as those of R²⁰¹ (excluding a halogen atom).

Of these, since the phosphorescent properties of the polymerizable compound are excellent, R³⁰¹ to R³¹⁰ are preferably each independently hydrogen atom, a fluorine atom, cyano group, methyl group, t-butyl group, dimethylamino group, butoxy group or 2-ethyl hexyloxy group, and more preferably R³⁰² is t-butyl group and R³⁰¹ to R³¹⁰ excluding R³⁰² are each hydrogen atom.

In each ring of R³⁰¹ to R³⁰⁴ and R³⁰⁵ to R³⁰⁸, two groups, which are adjacent through two carbon atoms, may bond each other to form a condensed ring. R³¹¹ is hydrogen atom or an alkyl group having 1 to 12 carbon atoms similar to R²¹⁶. Examples of the alkyl group having 1 to 12 carbon atoms may include the alkyl groups as described above. Of these, R³¹¹ is preferably hydrogen atom because the carrier-transporting ability of the polymerizable compound is excellent.

X³ is a single bond or a group represented by any of the following formulas (X31) to (X34).

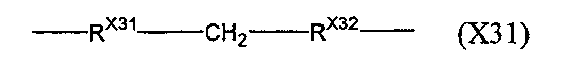

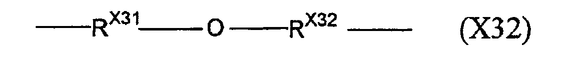

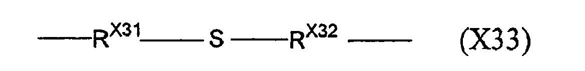

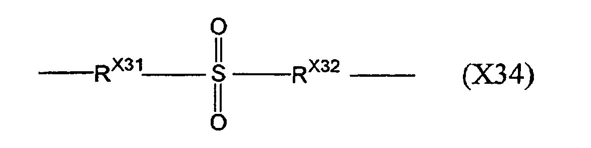

In the formulas, R^{X31} is a single bond or an alkylene group having 1 to 12 carbon atoms, and R^{X32} is a single bond, an alkylene group having 1 to 12 carbon atoms or a phenylene group. The preferable embodiment and the reason of X³ are similar to those in X²_{.}

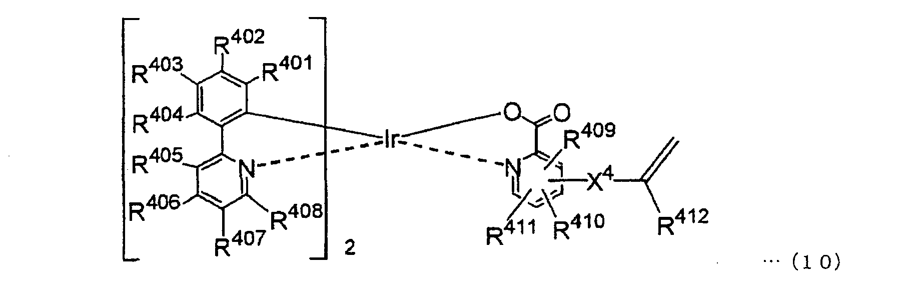

In the formula (10), R⁴⁰¹ to R⁴¹¹ are each independently the same atom or substituent as those of R²⁰¹. Of these, since the phosphorescent properties are excellent, R⁴⁰¹ to R⁴¹¹ are preferably each independently hydrogen atom, a fluorine atom, cyano group, methyl group, t-butyl group, dimethylamino group, butoxy group or 2-ethyl hexyloxy group, and more preferably R⁴⁰² is t-butyl group and R⁴⁰¹ to R⁴¹¹ excluding R⁴⁰² are each independently hydrogen atom.

In each ring of R⁴⁰¹ to R⁴⁰⁴, R⁴⁰⁵ to R⁴⁰⁸ and R⁴⁰⁹ to R⁴¹¹, two groups, which are adjacent through two carbon atoms, may bond each other to form a condensed ring.
R⁴¹² is the same atom or substituent as those of R²¹⁶, and the preferable embodiment and the reason thereof are similar to those in R²¹⁶.

X⁴ is a single bond or a group represented by any of the following formulas (X41) to (X44).

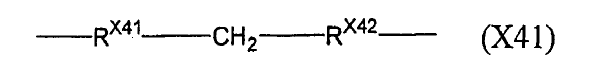

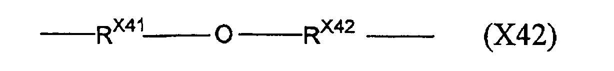

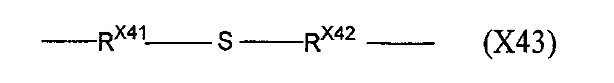

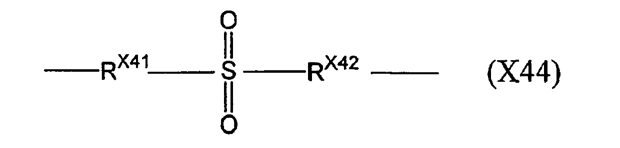

In the formulas, R^{X41} is a single bond or an alkylene group having 1 to 12 carbon atoms, and R^{X42} is a single bond, an alkylene group having 1 to 12 carbon atoms or a phenylene group. The preferable embodiment of X⁴ and the reason thereof are similar to those in X².

Non-limiting examples of the polymerizable phosphorescent compound used in the present invention may include the compounds as described in JP-A-2003-119179, JP-A-2003-113246, JP-A-2003-206320, JP-A-2003-147021, JP-A-2003-171391, JP-A-2004-346312, JP-A-2006-008996, JP-A-2007-023269 and JP-A-2007-084612.

More specific examples of the polymerizable phosphorescent compound preferably include the following compounds.

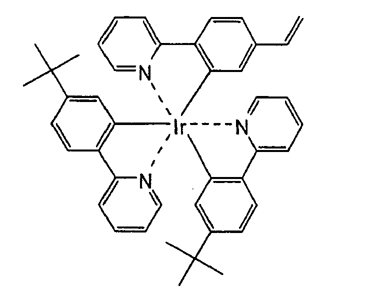

The above polymerizable phosphorescent compound may be used singly or two or more may be combined for use.
The polymerizable phosphorescent compound can be prepared by, for example, allowing iridium chloride to react with a phenyl pyridine derivative, thereby preparing a dinuclear complex of iridium, and allowing it to react with a ligand having a polymerizable functional group (a ligand coordinated in the right side of Ir in the above formulas (8) to (10)). In producing the polymer compound (II), examples of the other polymerizable compounds optionally used are similar to those in the embodiment 1.

The production of the polymer compound (II) is carried out using the above-described polymerizable compounds by any of radical polymerization, cation polymerization, anion polymerization and addition polymerization, preferably radical polymerization.

The weight average molecular weight of the polymer compound (II) is similar to that in the embodiment 1. The solubility of the polymer compound (II) in an organic solvent is similar to that in the embodiment 1.
In the polymer compound (II), when the number of the constituting unit derived from the polymerizable phosphorescent compound is taken as m and the number of the constituting unit derived from the polymerizable compound having carrier-transporting properties is taken as n (m and n are integers of 1 or more), the proportion of the constituting units derived from the polymerizable phosphorescent compound to all the constituting units, namely, the value of m/(m+n) is preferably 0.001 to 0.5, more preferably 0.001 to 0.2. When the value of m/(m+n) is in the above range, organic EL elements having high carrier mobility, low influence by concentration quenching and high light-emitting efficiency can be prepared. The proportion of each constituting unit of the above polymer compound is determined by ICP element analysis and ¹³C-NMR measurement.

Appropriately regulating the proportion of the polymerizable compound having charge-transporting properties and the polymerizable phosphorescent compound in the above ranges, the polymerization is carried out, to prepare the polymer compound (II) having a desired structure. The polymer compound (II) may be any one of a random copolymer, a block copolymer and an alternating copolymer.

### <Embodiment 3>

The polymer compound (III) of the present invention (Embodiment 3) comprises a constituting unit derived from at least one polymerizable compound having charge-transporting properties selected from the compounds represented by the above formulas (1) to (3), preferably the formulas (4) to (6), more preferably the formulas (1-1) to (3-7), a constituting unit derived from a polymerizable compound having light-emitting properties and a constituting unit derived from a polymerizable compound having positive hole-transporting properties. The polymer compound (III) is obtainable by polymerizing at least one polymerizable compound having charge-transporting properties selected from the compounds represented by the formulas (1) to (3), preferably the formulas (4) to (6), more preferably the formulas (1-1) to (3-7), the polymerizable compound having light-emitting properties and the polymerizable compound having positive hole-transporting properties.

The polymerizable compound having charge-transporting properties selected from those represented by the above formulas (1) to (3), preferably (4) to (6), more preferably (1-1) to (3-7) has the same meanings as those of the polymerizable compound having charge-transporting properties used in the embodiment 1 and the polymerizable compound having light-emitting properties has the same meanings as those of the polymerizable compound having light-emitting properties used in the embodiment 2, and further, the preferred embodiments and the reasons thereof are also similar.

Preferable examples of the polymerizable compound having positive hole-transporting properties are a carbazole derivative and a triaryl amine derivative each containing a substituent having a polymerizable functional group.
Examples of the carbazole derivative and triaryl amine derivative each containing a substituent having a polymerizable functional group may include N,N'-diphenyl-N,N'-(3-methylphenyl)-1,1'-biphenyl-4,4'-diamin e (TPD), N,N,N',N'-tetrakis(3-methylphenyl)-1,1'-(3,3'-dimethyl)biphen yl-4,4'-diamine (HMTPD),
4,4',4"-tris(3-methylphenylphenylamino)triphenylamine (m-MTDATA), 4,4'-biscarbazolyl biphenyl(CBP),
4,4'-biscarbazolyl-2,2'-dimethylbiphenyl (CDBP) and 4,4',4"-tris(carbazolyl-9-yl)triphenylamine (TCTA).

The polymerizable compound having positive hole-transporting properties may be used singly or two or more may be combined for use.
The polymerizable compound having positive hole-transporting properties represented by the following formulas (11) or (12) is suitable for the present invention because of having excellent carrier-transporting ability and excellent photo physical properties.

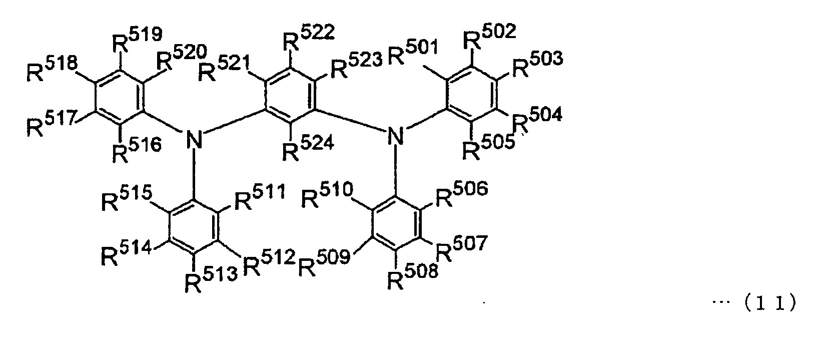

In the formula (11), at least one of R⁵⁰¹ to R⁵²⁴ is a substituent having a polymerizable functional group, and R⁵⁰¹ to R⁵²⁴, which are not the substituents having a polymerizable functional group, are each independently an atom or a substituent selected from the group consisting of hydrogen atom, a halogen atom, a cyano group, an alkyl group having 1 to 10 carbon atoms, an aryl group having 6 to 10 carbon atoms, an amino group optionally substituted with an alkyl group having 1 to 10 carbon atoms, an alkoxy group having 1 to 10 carbon atoms, a carbazolyl group and a silyl group.

Examples of the atom or the substituent may include the same as those described on halogen atom, the alkyl group having 1 to 10 carbon atoms, the aryl group having 6 to 10 carbon atoms, the alkyl group having 1 to 10 carbon atoms, the alkoxy group having 1 to 10 carbon atoms. The carbazolyl group may have a substituent such as methyl group, ethyl group, t-butyl group or methoxy group.

In R⁵⁰¹ to R⁵⁰⁵, R⁵⁰⁶ to R⁵¹⁰, R⁵¹¹ to R⁵¹⁵, R⁵¹⁶ to R⁵²⁰ and R⁵²¹ to R⁵²³, adjacent two groups through two carbon atoms, which form a ring, may bond each other to form a condensed ring.

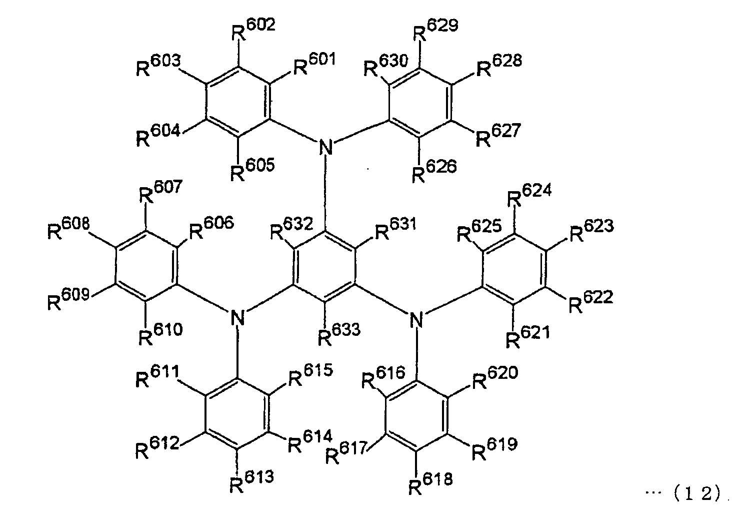

In the formulas (12), at least one of R⁶⁰¹ to R⁶³³ is a substituent having a polymerizable functional group, and R⁶⁰¹ to R⁶³³, which are not the substituents having a polymerizable functional group, are each independently an atom or a substituent selected from the group consisting of hydrogen atom, a halogen atom, a cyano group, an alkyl group having 1 to 10 carbon atoms, an aryl group having 6 to 10 carbon atoms, an amino group optionally substituted with an alkyl group having 1 to 10 carbon atoms, an alkoxy group having 1 to 10 carbon atoms and a silyl group.

Examples of the atom or the substituent may include the same atom or the substituents as those of the halogen atom, the alkyl group having 1 to 10 carbon atoms, the aryl group having 6 to 10 carbon atoms, the alkyl group having 1 to 10 carbon atoms and the alkoxy group having 1 to 10 carbon atoms as described above.

In R⁶⁰¹ to R⁶⁰⁵, R⁶⁰⁶ to R⁶¹⁰, R⁶¹¹ to R⁶¹⁵, R⁶¹⁶ to R⁶²⁰, R⁶²¹ to R⁶²⁵ and R⁶²⁶ to R⁶³⁰, adjacent two groups through two carbon atoms, which form a ring, may bond each other to form a condensed ring.

Concerning to the polymerizable compound represented by the formula (11), in each of R⁵⁰¹ to R⁵⁰⁵, R⁵⁰⁶ to R⁵¹⁰, R⁵¹¹ to R⁵¹⁵ and R⁵¹⁶ to R⁵²⁰, at least one is preferably the atom other than hydrogen atom or the substituent. In this case, R⁵⁰¹ to R⁵²⁴ other than the polymerizable functional group, the atom or the substituent are hydrogen atoms. Furthermore, concerning to the polymerizable compound represented by the formula (12), in each of R⁶⁰¹ to R⁶⁰⁵, R⁶⁰⁶ to R⁶¹⁰, R⁶¹¹ to R⁶¹⁵, R⁶¹⁶ to R⁶²⁰, R⁶²¹ to R⁶²⁵ and R⁶²⁶ to R⁶³⁰, at least one is preferably the atom other than hydrogen atom or the substituent. In this case, R⁶⁰¹ to R⁶³³ other than the polymerizable functional group, the atom or the substituent are hydrogen atoms.

As the substituent having the polymerizable functional group, a substituent represented by the formula (7) is preferred.

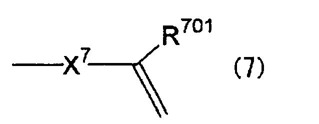

R⁷⁰¹ is hydrogen atom or an alkyl group having 1 to 12 carbon atoms. Concerning to R⁷⁰¹, the preferable range and the reason thereof are similar to those as described in the polymerizable compound having charge-transporting properties in the embodiment 1.

In the formula (7), X⁷ is a single bond or a group represented by any of the formulas (X71) to (X74). Concerning to X⁷, the preferable range and the reason thereof are similar to those as described in the polymerizable compound having charge-transporting properties in the embodiment 1.

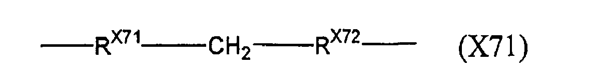

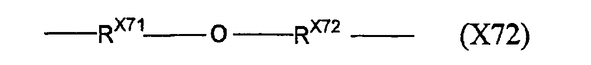

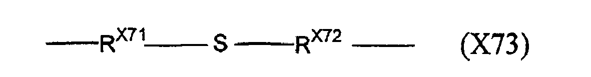

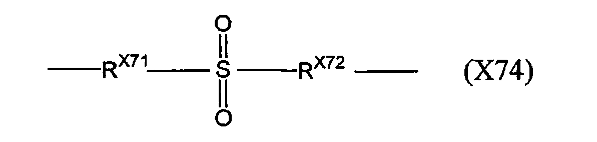

Specific examples of the polymerizable compound having positive hole-transporting properties may include compounds represented by the following formulas (15-1) to (15-10).

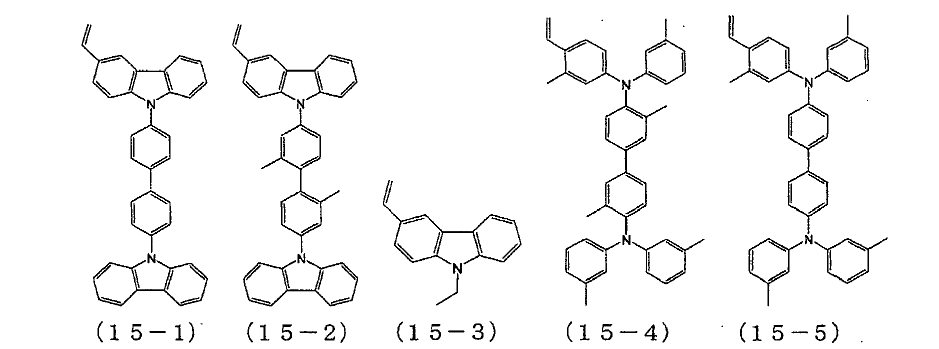

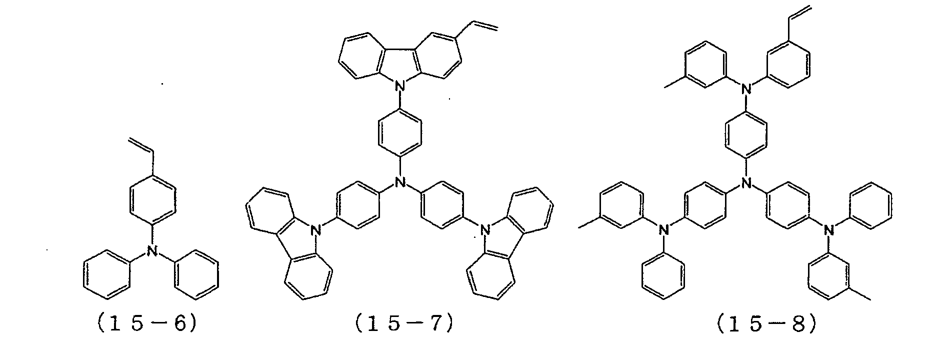

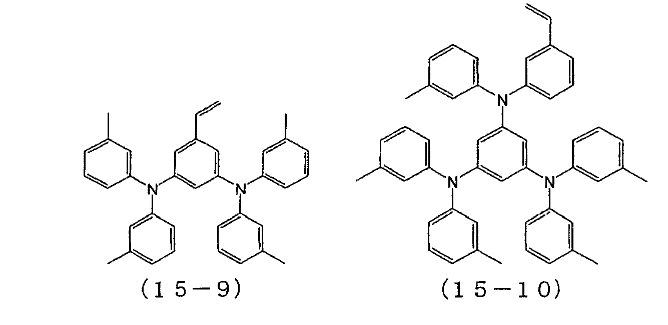

The polymerizable compound having positive hole-transporting properties may be used singly or two or more may be combined for use.
The compound represented by the formula (11) can be prepared by, for example, palladium catalyst substitution reaction of a m-phenylene diamine derivative and halogenated aryl or palladium catalyst substitution reaction of diarylamine and a m-dibromobenzene derivative. The method for substitution reaction is disclosed in, for example, Tetrahedron Letters, 1998, Vol. 39, p. 2367. The compound represented by the formula (12) can be prepared by, for example, palladium catalyst substitution reaction of 1,3,5-triaminobenzene and halogenated aryl or palladium catalyst substitution reaction of diarylamine and 1,3,5-trihalogenated benzene. The method for substitution reaction is disclosed in, for example, Tetrahedron Letters, 1998, Vol. 39, p. 2367.

In producing the polymer compound (III), other polymerizable compounds further optionally used are the same compounds as in the embodiment 1.
The production of the polymer compound (III) may be carried out using the above polymerizable compounds by any of radical polymerization, cation polymerization, anion polymerization and addition polymerization, preferably by radical polymerization.

The weight average molecular weight of the polymer compound (III) is similar to that in the embodiment 1. Furthermore, the solubility of the polymer compound (III) in an organic solvent is similar to that in the embodiment 1.

In the polymer compound (III), when the number of the constituting unit derived from the polymerizable compound having phosphorescent properties is taken as m and the number of the constituting unit derived from the polymerizable compound having carrier-transporting properties is taken as n (m and n are integers of 1 or more), the proportion of the constituting units derived from the polymerizable compound having phosphorescent properties to all the constituting units, namely, the value of m/(m+n) is preferably 0.001 to 0.5, more preferably 0.001 to 0.2. When the value of m/ (m+n) is in the above range, organic EL elements having high carrier mobility, low influence of concentration quenching and high light-emitting efficiency can be prepared.

In the polymer compound (III), when the number of the constituting unit derived from the polymerizable compound having positive hole-transporting properties is taken as x and the number of the constituting unit derived from the polymerizable compound having charge-transporting properties is taken as y (x and y are integers of 1 or more), x, y and n described above satisfy the following relation n = x + y. Concerning the proportion of the number of the constituting unit derived from the polymerizable compound having carrier-transporting properties to the number of the constituting unit derived from the polymerizable compound having positive hole-transporting properties x/n, and the proportion of the number of the constituting unit derived from the polymerizable compound having carrier-transporting properties to the number of the constituting unit derived from the polymerizable compound having charge-transporting properties y/n, the optimum values are determined by the charge-transporting ability and concentration of each constituting unit. When the light-emitting layer of an organic EL element is formed by only the polymer compound (III), the values of x/n and y/n are each in the range of preferably 0.05 to 0.95, more preferably 0.20 to 0.80. Herein x/n + y/n = 1. The proportion of each constituting unit of the polymer compounds is determined by ICP element analysis and ¹³C-NMR measurement.

When polymerization is carried out by appropriately regulating the proportion of the polymerizable compound having charge-transporting properties, the polymerizable compound having phosphorescent properties and the polymerizable compound having positive hole-transporting properties in the above range, the polymer compound (III) having a desired structure can be prepared. The polymer compound (III) may be any one of a random copolymer, a block copolymer and an alternating copolymer.

### <Embodiment 4>

In the organic EL element of the present invention (Embodiment 4), one light-emitting layer, which comprises the polymer compound (I) and a polymer compound (I'), is provided between an anode and a cathode, wherein the polymer compound (I') has the constituting units derived from a light-emitting compound and a polymerizable compound having positive hole-transporting properties. In this case, the light-emitting layer contains the light-emitting compound in an amount of 0.1 to 50 parts by mass, more preferably 0.5 to 30 parts by mass and the polymer compound (I') in an amount of 10 to 200 parts by mass, more preferably 50 to 150 parts by mass based on 100 parts by mass of the polymer compound (I). As described above, forming the light-emitting layer from the polymer compound (I), the light-emitting compound and the polymer compound having positive hole-transporting properties (I'), organic EL elements having high light-emitting efficiency can be prepared even if other organic material layers are not provided.

Examples of the light-emitting compound are preferably phosphorescent compounds, more preferably an iridium complex. Preferably usable examples of the iridium complex are the following complexes (E-1) to (E-39).

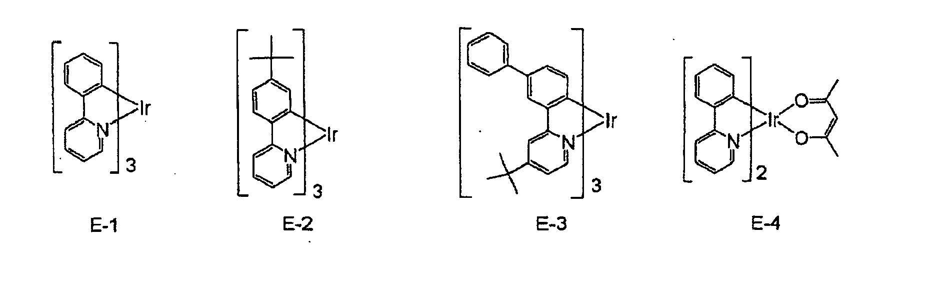

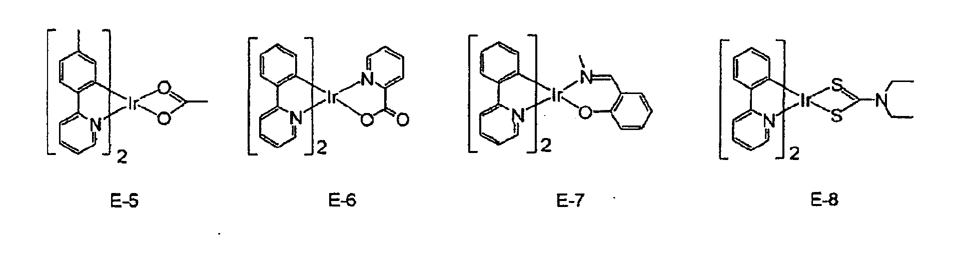

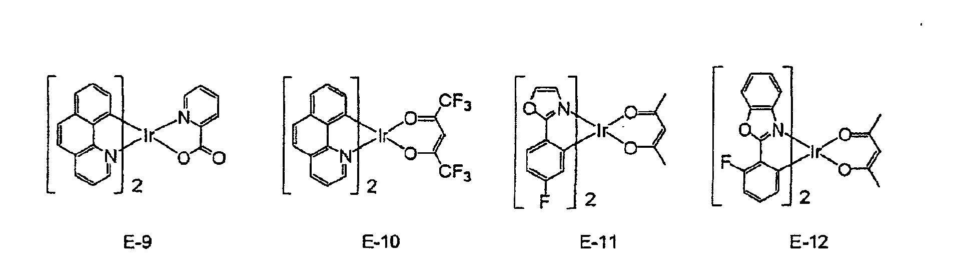

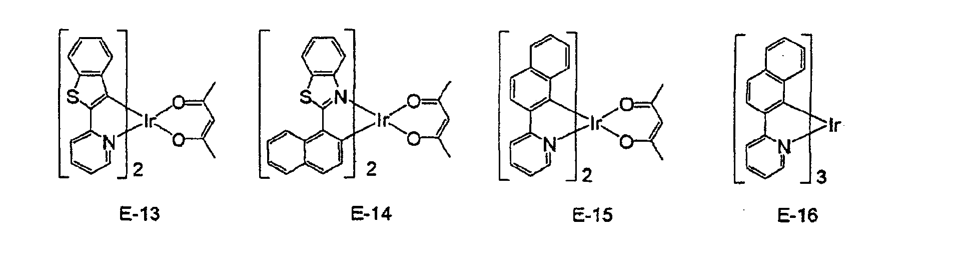

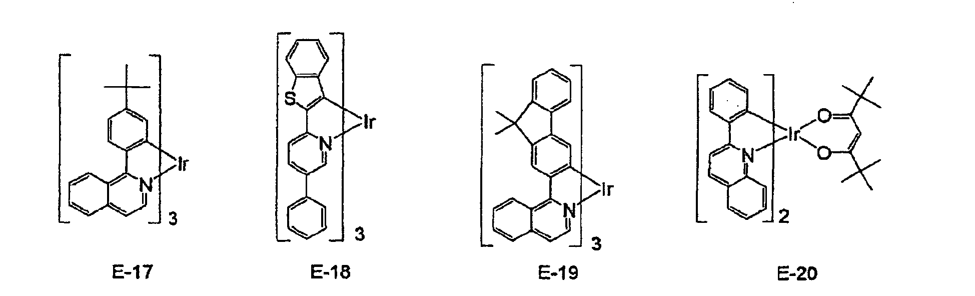

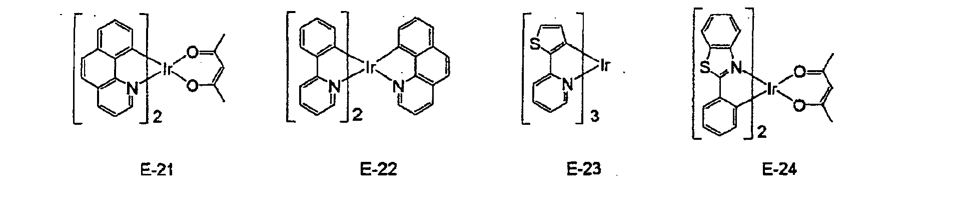

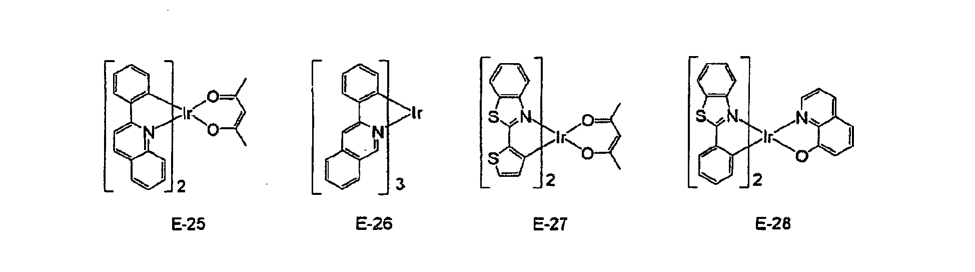

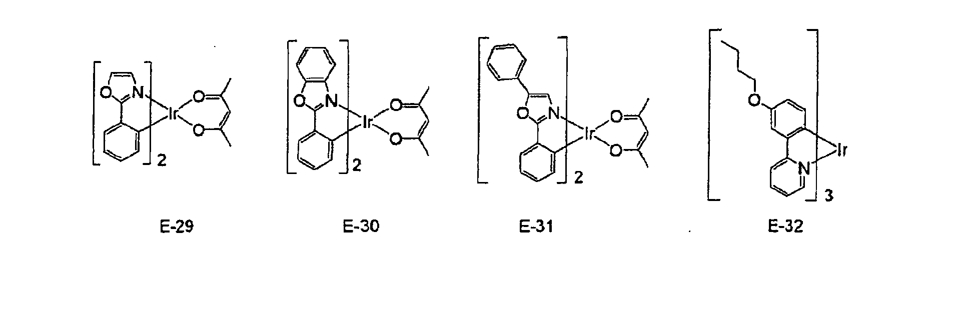

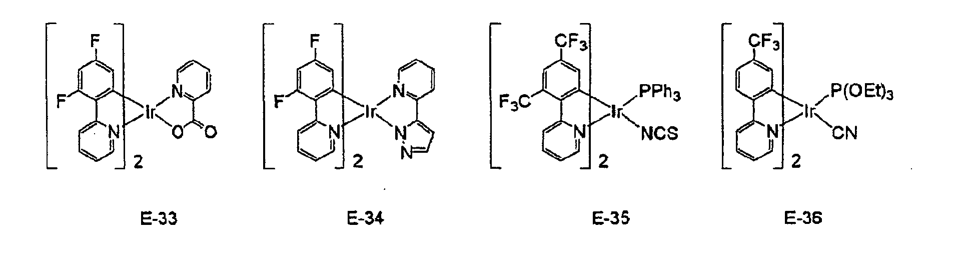

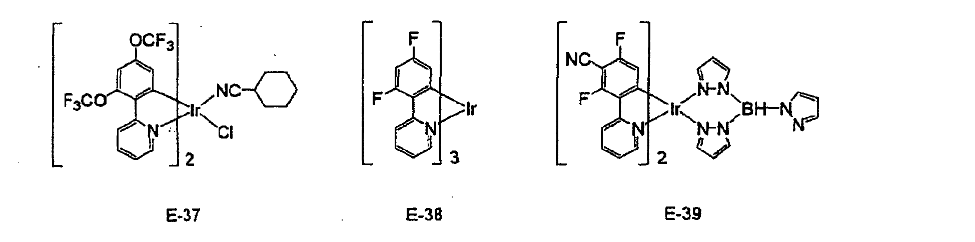

The light-emitting compound may be used singly and two or more may be combined for use.
The polymer compound (I') is obtainable by polymerizing the polymerizable compound having positive hole-transporting properties. The above polymerizable compound having positive hole-transporting properties has the same meaning as the polymerizable compound having positive hole-transporting properties used in the embodiment 3, and the preferred range and the reason thereof are similar to those in the embodiment 3.

The polymer compound (I') may be produced using the above-described polymerizable compounds by any of radical polymerization, cation polymerization, anion polymerization and addition polymerization, preferably radical polymerization.

The polymer compound (I') has a weight average molecular weight of usually 1, 000 to 2, 000, 000, preferably 5, 000 to 500,000. The polymer compound (I') preferably has a weight average molecular weight in the above range, because the polymer compound (I') is soluble in an organic solvent and uniform thin films are prepared. The weight average molecular weight is a value determined by measuring at 40°C using tetrahydrofuran as a solvent with gel permeation chromatography (GPC) method. The solubility of the polymer compound (I') in an organic solvent is the same as that in the embodiment 1.

In the production of the organic EL element having one light-emitting layer, which comprises the polymer compound (I), the light-emitting compound and the polymer compound (I'), between an anode and a cathode, the light-emitting layer is usually formed on an anode provided on a substrate in the following manner. First, a solution in which the polymer compound (I), the light-emitting compound and the polymer compound (I') are dissolved is prepared. Although a solvent used in the preparation of the solution is not particularly limited, examples of the solvent are chlorine solvents such as chloroform, methylene chloride, dichloroethane etc; ether solvents such as tetrahydrofuran, anisole etc; aromatic hydrocarbon solvents such as toluene, xylene etc; ketone solvents such as acetone, methylethyl ketone etc; and ester solvents such as ethyl acetate, butyl acetate, ethyl cellosolve acetate etc. Next, the solution thus prepared is applied on the substrate by wet film forming methods such as spin coating method, casting method, micro-gravure coating method, gravure coating method, bar coating method, roll coating method, wire bar coating method, dip coating method, spray coating method, screen printing method, flexographic printing method, offset printing method or ink jet printing method, to form a film. For example, in the spin coating method or the dip coating method, depending on the compounds used and the film forming conditions, the solution preferably contains the light-emitting compound in an amount of 0.5 to 30 parts by mass, the polymer compound (I') in an amount of 10 to 200 parts by mass and the solvent in an amount of 1000 to 20000 parts by mass based on 100 parts by mass of the polymer compound (I).

Providing a cathode on the light-emitting layer thus formed, the organic EL element of the embodiment 4 can be prepared.
As the substrate used in the embodiment 4, a transparent substrate having insulating properties against the emitting wavelength of the light-emitting material is favorably used. Examples of the substrate are glasses and transparent plastics such as PET (polyethylene terephthalate), polycarbonate etc.

As an anode material used in the embodiment 4, it is preferred to use known transparent conductive materials, such as ITO (indium tin oxide), tin oxide, zinc oxide and conductive polymers such as polythiophene, polypyrol, polyaniline, etc. The electrode formed by the transparent conductive material has a surface resistance of preferably 1 to 50 Ω/□ (ohm/square). The anode has a thickness of preferably 50 to 300 nm.

As the cathode material used in the embodiment 4, it is preferred to use known cathode materials, for example, alkali metals such as Li, Na, K, Cs, etc; alkali earth metals such as Mg, Ca, Ba, etc; Al; MgAg alloy; alloys of Al and an alkali metal or an alkali earth metal, such as AlLi, AlCa, etc. The cathode has a thickness of preferably 10 nm to 1 µm, more preferably 50 to 500 nm. When a metal having high activity such as an alkali metal or an alkali earth metal is used, the cathode has a thickness of preferably 0.1 to 100 nm, more preferably 0.5 to 50 nm. In this case, on the cathode, a metal layer stable to the air is laminated for protecting the cathode metal. Examples of the metal forming the metal layer may include Al, Ag, Au, Pt, Cu, Ni, Cr, etc. The metal layer has a thickness of preferably 10 nm to 1 µm, more preferably 50 to 500 nm.

Examples of the film forming method using the anode material may include electron beam vapor deposition method, sputtering method, chemical reaction method and coating method, and examples of the film forming method using the cathode material may include resistance heat vapor deposition method, electron beam vapor deposition method, sputtering method and ion plating method.

### <Embodiment 5>

In the organic EL element of the present invention (Embodiment 5), one light-emitting layer, which comprises a specific polymer compound (II) and a polymer compound (I'), is provided between an anode and a cathode. In this case, the light-emitting layer contains the polymer compound (I') in an amount of preferably 10 to 200 parts by mass, more preferably 50 to 150 parts by mass based on 100 parts by mass of the polymer compound (II). In forming the light-emitting layer from the polymer compound having electron-transporting properties and light-emitting properties (1) and the polymer compound having positive hole-transporting properties (I'), organic EL elements having high light-emitting efficiency can be prepared even if other organic material layers are not provided.

The light-emitting layer is usually formed on the anode provided on the substrate in the following way. First, a solution in which the polymer compound (II) and the positive hole-transporting compound are dissolved is prepared. The solvent used in the preparation of the solution is the same as that used in the embodiment 4. The film forming method of the solution is similar to that of the embodiment 4. In the spin coating method or the dip coating method, depending on the compound used and the film forming conditions, for example, the solution preferably contains the polymer compound (I') in an amount of 10 to 200 parts by mass and the solvent in an amount of 1000 to 20000 parts by mass based on 100 parts by mass of the polymer compound (II).

Providing the cathode on the light-emitting layer thus formed, the organic EL element of the embodiment 5 is prepared. Furthermore, the substrate, the anode material, the cathode material and the film forming methods using the anode material and the cathode material in the embodiment 5 are similar to those of the embodiment 4.

### <Embodiment 6>

In the organic EL element of the present invention (Embodiment 6), one light-emitting layer, which comprises a specific polymer compound (III), is provided between an anode and a cathode. In forming the light-emitting layer by the use of the polymer compound having charge-transporting properties, phosphorescent properties and positive hole-transporting properties (III), organic EL elements having high light-emitting efficiency can be prepared even if other organic material layers are not provided. Furthermore, the embodiment 6 has a merit such that the production step can be more simplified because the light-emitting layer is formed from only the polymer compound (III).

The light-emitting layer is usually formed on the anode provided on the substrate in the following way. First, a solution in which the polymer compound (III) is dissolved is prepared. The solvent used in the preparation of the solution is the same as that used in the embodiment 4. The film forming method of the solution is similar to that of the embodiment 4. In the spin coating method or the dip coating method, depending on the compound used and the film forming conditions, for example, the solution preferably contains the solvent in an amount of 1000 to 20000 parts by mass based on 100 parts by mass of the polymer compound (III) . Providing the cathode on the light-emitting layer thus formed, the organic EL element of the embodiment 6 is prepared.

Furthermore, the substrate, the anode material, the cathode material and the film forming methods using the anode material and the cathode material in the embodiment 6 are similar to those in the embodiment 4.

### <Embodiment 7>

The organic EL element of the present invention (Embodiment 7) comprises, between an anode and a cathode, the light-emitting layer as described in any one of the embodiments 4 to 6, and optionally comprises other organic layers.

Examples of the other organic layers are a positive hole-transporting layer, a charge-transporting layer, a positive hole-block layer and a buffer layer. Providing these organic layers, the light-emitting efficiency can be further enhanced.
One example of the structure of the organic EL element (Embodiment 7) according to the present invention is shown in Fig. 1. In Fig. 1, between an anode (2) and a cathode (6) provided on a transparent substrate (1), a positive hole-transporting layer (3), a light-emitting layer (4) as described in the embodiment 4 to 6, and an electron-transporting layer (5) are provided in this order.
In the embodiment 7, between the anode (2) and the cathode (6), any one of 1) the positive hole-transporting layer/the light-emitting layer and 2) the light-emitting layer/ the electron-transporting layer may be provided.

Each organic layer may be formed by mixing a polymer material and the like as a binder. Examples of the polymer material may include polymethyl methacrylate, polycarbonate, polyester, polysulfone and polyphenylene oxide.

Furthermore, each layer may be formed by each singly using the compound having positive hole-transporting properties and the compound having electron-transporting properties used in the positive hole-transporting layer and the electron-transporting layer, or mixing the compounds with materials having different functions.

Examples of the compound having positive hole-transporting properties used for forming the positive hole-transporting layer may include TPD (N,N'-dimethyl-N,N'-(3-methylphenyl)-1,1'-biphenyl-4,4'diamin e) ; α-NPD (4,4'-bis [N-(1-naphthyl)-N-phenylamino]biphenyl); low molecular triphenyl amine derivatives such as m-MTDATA (4,4',4"-tris(3-methylphenylphenylamino)triphenylamine etc; polyvinyl carbazole ; polymer compounds obtainable by introducing a polymerizable functional group to the above triphenyl amine derivative and polymerizing; fluorescent polymer compounds such as polyparaphenylene vinylene, polydialkylfluorene, etc. Examples of the polymer compound are polymer compounds having a triphenyl amine skeleton as disclosed in JP-A-H8(1996)157575. The compound having positive hole-transporting properties may be used singly or two or more may be mixed for use, and further, a different compound having positive hole-transporting properties may be laminated on them. The positive hole-transporting layer usually has a thickness, which depends on the conductivity of the positive hole-transporting layer, of preferably 1 nm to 5 µm, more preferably 5 nm to 1 µm, particularly preferably 10 nm to 500 nm.

Examples of the compound having electron-transporting properties for forming the electron-transporting layer may include quinolinol derivative metal complexes such as Alq3 (aluminum trisquinolinolate) etc; low molecular compounds such as oxadiazole derivative, triazole derivative, imidazole derivative, triazine derivative, triaryl borane derivative, etc; and polymer compounds obtainable by introducing a polymerizable substituent to the above low molecule compound and polymerizing. Examples of the polymer compound may include poly PBD etc as disclosed in JP-A-H10(1998)-1665. The compound having electron-transporting properties may be used singly or two or more may be mixed for use, and further a different compound having electron-transporting properties may be laminated on them. The electron-transporting layer usually has a thickness, which depends on the conductivity of the electron-transporting layer, of preferably 1 nm to 5 µm, more preferably 5 nm to 1 µm, particularly preferably 10 nm to 500 nm.

Adjacent to the cathode side of the light-emitting layer, a positive hole-blocking layer may be provided in order to depress passing of positive holes through the light-emitting layer and to re-combine positive holes with electrons efficiently in the light-emitting layer. For forming the positive hole-blocking layer, known materials such as a triazole derivative, an oxadiazole derivative, a phenanethroline derivative, etc are used.

Moreover, between the anode and the positive hole-transporting layer, or between the anode and the organic layer laminated adjacently to the anode, a buffer layer may be provided in order to buffer the injection barrier in positive hole injection. In order to form the buffer layer, known materials such as copper phthalocyanine, a mixture of polyethylene dioxythiophene and polystyrene sulfonate (PEDOT:PSS), etc are used.

Furthermore, between the cathode and the electron-transporting layer, or between the cathode and the organic layer laminated adjacently to the cathode, an insulating layer having a thickness of 0.1 to 10 nm may be provided in order to enhance the electron injecting efficiency. For forming the insulating layer, known materials such as lithium fluoride, sodium fluoride, magnesium fluoride, magnesium oxide, alumina, etc are used.

As the processes for forming the positive hole-transporting layer and the electron-transporting layer, it is possible to use, for example, dry film forming methods such as resistance heat vapor deposition method, electron beam vapor deposition method or sputtering method; and wet film forming methods such as spin coating method, casting method, micro-gravure coating method, gravure coating method, bar coating method, roll coating method, wire bar coating method, dip coating method, spray coating method, screen printing method, flexographic printing method, offset printing method and ink jet printing method. In the low molecular compound, it is preferred to use the dry film forming method, and in the polymer compound, it is preferred to use the wet film forming method.

### <Uses>

The organic EL element according to the present invention is favorable for image display devices as pixels by a matrix system or a segment system with known methods. The organic EL element is also favorable for a surface emitting light source without forming pixels.

The organic EL element of the present invention is favorable for displays, back lights, electron photographs, illumination light sources, recording light sources, exposure light sources, reading light sources, marks, signboards, interiors, optical communication systems, etc.

### EXAMPLE

The present invention is further described in more detail with reference to the following examples hereinafter, but it is not limited by the examples. The methods for measuring various physical properties of synthesized compounds and the devices used in the measurements are shown below.

### (1) ¹H-NMR, ¹³C-NMR

JNM EX270 manufactured by JEOL
270 Mz, Solvent: Heavy chloroform

### (2) Gel permeation chromatography (GPC) (Molecular weight measurement)

Column: Shodex KF-G + KF804L + KF802 + KF801
Elute: Tetrahydrofurane (THF)
Temperature: 40°C
Detector: RI (Showdex RI-71)

### (3) ICP element analysis

ICPS8000 manufactured by Shimadzu Corporation

### [Synthetic Example 1] Synthesis of Polymerizable compound 1

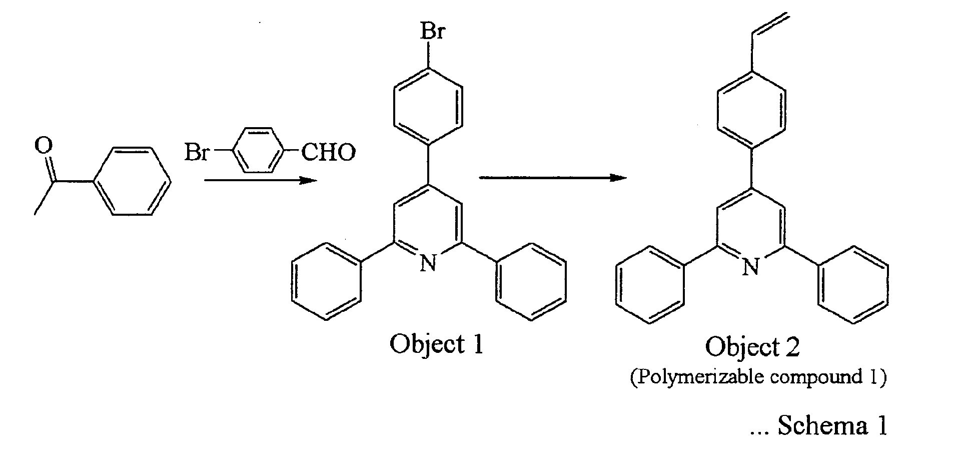

### (1-1) Synthesis of Object 1

The synthesis of the object 1 is described with reference to the schema 1.

To a 100 mL round bottom flask, 3.61 g (30 mmol) of acetophenone, 2.78 g (15 mmol) of 4-bromobenzaldehyde, 14.8 g (192 mmol) of ammonium acetate and 30 mL of acetic acid were fed, and stirred under reflux for 9 hr. After cooling, a solid deposited was filtered off and eluted with hexane and chloroform in the proportion of 80: 20 by silica gel column chromatography to prepare the object 1 in an amount of 1.22 g in a yield of 21 mol%.

### (1-2) Synthesis of Object 2 (Polymerizable compound 1)

The synthesis of the object 2 is described with reference to the schema 1.

To 100 mL of a 2-necked flask, 1.22 g (3.15 mmol) of the object 1, 0.70 g (3.78 mmol) of vinyl boric acid dibutyl ester, 4.35 g (31.5 mmol) of potassium carbonate, 0.61 g (1.89 mmol) of tetrabutyl ammonium bromide, 40 mg of ditertialbutyl cresol, 25 mL of toluene and 15 mL of water were fed and stirred under reflux in nitrogen for 1 hr. To this solution, 128 mg (0.112 mmol) of tetrakis (triphenyl phosphine palladium (O) was added and stirred under reflux in nitrogen for 1 hr. After cooling, to the mixture, ethyl acetate and water were added, and an organic layer was washed with water and saturated brine successively. After the organic layer was concentrated, a residue was eluted with hexane and chloroform in the proportion of 70 : 30 by silica gel column chromatography to prepare the object 2 in an amount of 0.64 g in a yield of 61 mol%.

### [Synthetic Example 2] Synthesis of Polymerizable compound 2

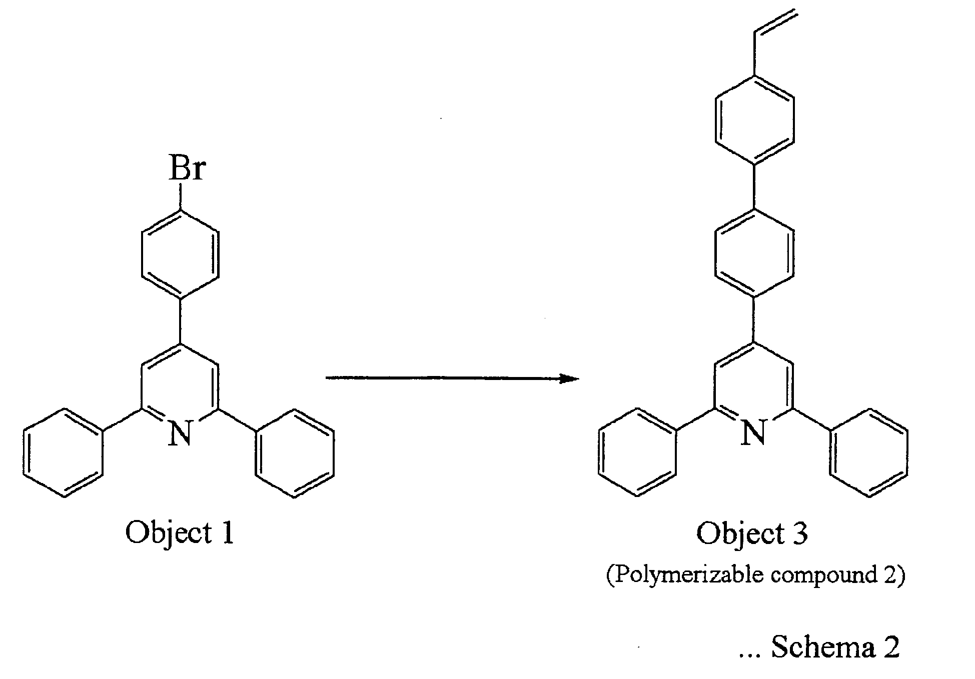

The synthesis of the compound 2 is described with reference to the schema 2.
To a 100 mL 2-necked flask, 1.00 g (2.60 mmol) of the object 1, 0.46 g (3.12 mmol) of styryl boric acid, 3.59 g (26.0 mmol) of potassium carbonate, 0. 50 g (1.56 mmol) of tetrabutyl ammonium bromide, 30 mg of ditertialbutyl cresol, 25 mL of toluene and 15 mL of water were fed and stirred under reflux in nitrogen for 1 hr. To this solution, 120 mg (0.104 mmol) of tetrakis(triphenyl phosphine) palladium (O) was added and stirred under reflux in nitrogen for 1 hr. After cooling, to the mixture, ethyl acetate and water were added, and an organic layer was washed with water and saturated brine successively. After the organic layer was concentrated, a residue was eluted with hexane and chloroform in the proportion of 65 : 35 by silica gel column chromatography to prepare the object 3 in an amount of 0.84 g in a yield of 78 mol%.

### [Synthetic Example 3] Synthesis of Polymerizable compound 3

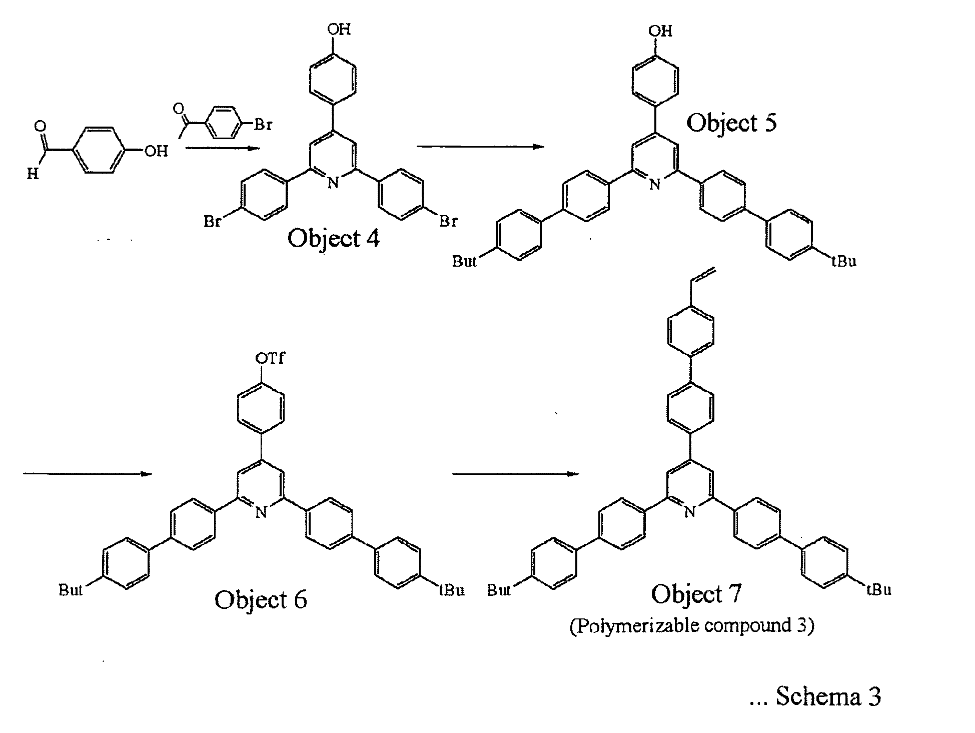

### (3-1) Synthesis of Object 4

The synthesis of the object 4 is described with reference to the schema 3.

To a 200 mL flask, 6.25 g (31.40 mmol) of 4'-bromoaceto phenone, 1.92 g (15.72 mmol) of 4-hydroxybenzaldehyde, 15.5 g (201.1 mmol) of ammonium acetate and 40 mL of acetic acid were fed and stirred under reflux for 8 hr. After cooling, a solid deposited was collected with filtration and washed with a small amount of methanol to prepare the object 4 in an amount of 3.25 g in a yield of 43 mol%.

### (3-2) Synthesis of Object 5

The synthesis of the object 5 is described with reference to the schema 3.
To a 100 mL 2-necked flask, 3.24 g (6.73 mmol) of the object 4, 2.64 g (14.8 mmol) of 4-tertialbutylphenyl boric acid, 9.31 g (67.33 mmol) of potassium carbonate, 1.33 g (4.00 mL) of
tetrabutyl ammonium bromide, 30 mL of toluene and 20 mL of water were fed and stirred under reflux in nitrogen for 1 hr. To this solution, 347 mg (0.40 mmol) of tetrakis(triphenyl phosphine) palladium (O) was added and stirred under reflux in nitrogen for 3 hr. After cooling, to the mixture, ethyl acetate and water were added, and an organic layer was washed with water and saturated brine successively. After the organic layer was concentrated, a residue was eluted with chloroform and ethyl acetate in the proportion of 98 : 2 by silica gel column chromatography to prepare the object 5 in an amount of 2.40 g in a yield of 60 mol%.

### (3-3) Synthesis of Object 6

The synthesis of the object 6 is described with reference to the schema 3.
To a 200 mL flask, 1.99 g (3.39 mmol) of the object 5, and 10 mL of pyridine were fed, and to the mixture, 0.7 mL (4.26 mmol) of trifluoromethane sulfonic acid anhydride was dropped under cooling with ice. After 1 hr, to the reaction solution, an appropriate amount of ice was added and 20 mL of 6N hydrochloric acid was added under cooling with ice. The solution was extracted with ethyl acetate, and an organic layer was washed with water and saturated brine successively. The organic layer was concentrated and a residue was eluted with hexane and chloroform in the proportion of 70 : 30 by silica gel column chromatography, to prepare the object 6 in an amount of 1.88 g in a yield of 77 mol%.

### (3-4) Synthesis of Object 7 (Polymerizable compound 3)

The synthesis of the object 7 is described with reference to the schema 3.
To a 100 mL 2-necked flask, 1.08 g (1.50 mmol) of the object 6, 0.27 g (1.80 mmol) of styryl boric acid, 2.07 g (15.0 mmol) of potassium carbonate, 0.29 g (0.90 mmol) of tetrabutylammonium bromide, 30 mg of ditertialbutyl cresol, 25 mL of toluene and 15 mL of water were fed and stirred under reflux in nitrogen for 1 hr. To the solution, 69 mg (0.06 mmol) of tetrakis(triphenyl phosphine)palladium (O) was added and stirred under reflux in nitrogen for 1 hr. After cooling, to the reaction solution, ethyl acetate and water were added, and an organic layer was washed with water and saturated brine successively. The organic layer was concentrated and a residue was eluted with hexane and chloroform in the proportion of 65 : 35 by silica gel column chromatography, to prepare the object 7 in an amount of 0.81 g in a yield of 80 mol%.

### [Synthetic Example 4] Synthesis of Polymerizable compound 4

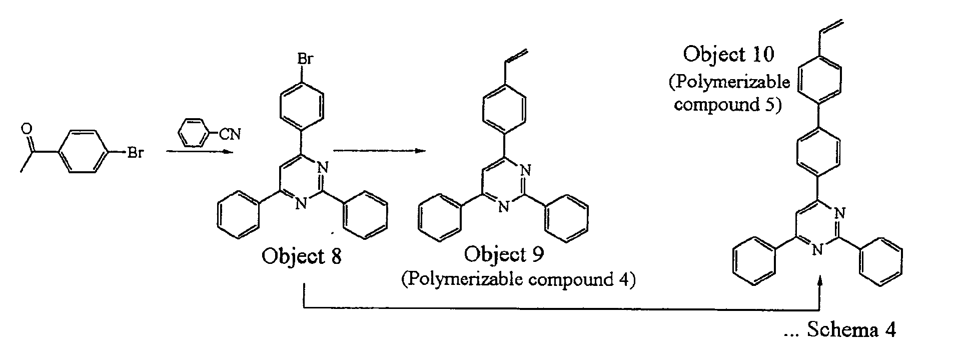

### (4-1) Synthesis of Object 8

The synthesis of the object 8 is described with reference to the schema 4.

To a 100 mL round bottom flask, 3.2 g (11.4 mmol) of trifluoromethane sulfonic acid anhydride, 2.17 g (21 mmol) of benzonitrile and 10 mL of anhydrous dichloromethane were fed. To this solution, 10 mL of an anhydrous dichloromethane solution of 1.99 g (10 mmol) of 4'-bromoacetophenone was dropped. After stirring at room temperature for 22 hr, a saturated sodium hydrocarbon solution was added slowly and an organic layer was washed with water and saturated brine. The organic layer was concentrated, and a residue was eluted with dichloromethane and diethyl ether in the proportion of 70 : 30 by silica gel column chromatography to prepare the object 8 in an amount of 3.17 g in a yield of 82 mol%.

### (4-2) Synthesis of Object 9 (Polymerizable compound 4)

The synthesis of the object 9 is described with reference to the schema 4.
To a 100 mL 2-necked flask, 1.22 g (3.15 mmol) of the object 8, 0.70 g (3.78 mmol) of vinyl boric acid dibutyl ester, 4.35 g (31.5 mmol) of potassium carbonate, 0.61 g (1.89 mmol) of tetrabutyl ammonium bromide, 40 mg of ditertial butyl cresol, 25 mL of toluene and 15 mL of water were fed and stirred under reflux in nitrogen for 1 hr. To this solution, 128 mg (0.112 mmol) of tetrakis(triphenylphosphine)palladium (O) was added and stirred under reflux in nitrogen for 1 hr. After cooling, ethyl acetate and water were added and an organic layer was washed with water and saturated brine successively. The organic layer was concentrated, and a residue was eluted with hexane and chloroform in the proportion of 65 : 35 by silica gel column chromatography to prepare the object 9 in an amount of 0.88 g in a yield of 84 mol%.

### [Synthetic Example 5] Synthesis of Polymerizable compound 5

The synthesis of the compound 5 is described with reference to the schema 4.
To a 100 mL 2-necked flask, 1.20 g (3.10 mmol) of the object 8, 0.55 g (3.74 mmol) of styryl boric acid, 4.28 g (31.0 mmol) of potassium carbonate, 0.60 g (1.87 mmol) of tetrabutyl ammonium bromide, 40 mg of ditertialbutyl cresol, 25 mL of toluene and 15 mL of water were fed and stirred under reflux in nitrogen for 1 hr. To this solution, 144 mg (0.124 mmol) of tetrakis(triphenylphosphine)palladium (O) was added and stirred under reflux in nitrogen for 1 hr. After cooling, ethyl acetate and water were added and an organic layer was washed with water and saturated brine successively. The organic layer was concentrated, and a residue was eluted with hexane and chloroform in the proportion of 65 : 35 by silica gel column chromatography to prepare the object 10 (polymerizable compound 5) in an amount of 1.00 g in a yield of 77 mol%.

### [Synthetic Example 6] Synthesis of Polymerizable compound 6

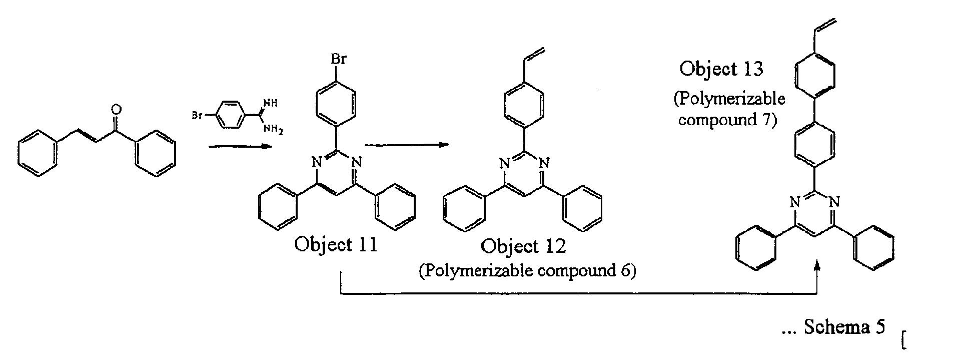

### (6-1) Synthesis of Object 11

The synthesis of the object 11 is described with reference to the schema 5.
To a 100 mL round bottom flask, 4. 17 g (20 mmol) of chalcone, 1.99 g (10 mmol) of 4-bromobenzamidine and 300 mL of ethanol were fed. To this solution, 100 mL of an ethanol solution of 1.12 g (20 mmol) of potassium hydroxide was dropped. After stirring under reflux for 3 hr, the mixture was cooled to room temperature, a resulting precipitate was collected with filtration and washed with pure water. This crude product was re-crystallized with glacial acetic acid to prepare the object 11 in an amount of 3.29 g in a yield of 85 mol%.

### (6-2) Synthesis of Object 12 (Polymerizable compound 6)

The synthesis of the object 12 is described with reference to the schema 5.

To a 100 mL 2-necked flask, 1.94 g (5 mmol) of the object 11, 1.10 g (6 mmol) of vinyl boric acid dibutyl ester, 6.91 g (50 mmol) of potassium carbonate, 0.61 g (3 mmol) of tetrabutyl ammonium bromide, 50 mg of ditertialbutyl cresol, 40 mL of toluene and 25 mL of water were fed and stirred under reflux in nitrogen for 1 hr. To this solution, 231 mg (0.2 mmol) of tetrakis(triphenylphosphine)palladium (O) was added and stirred under reflux in nitrogen for 1 hr. After cooling, ethyl acetate and water were added and an organic layer was washed with water and saturated brine successively. The organic layer was concentrated, and a residue was eluted with hexane and chloroform in the proportion of 60 : 40 by silica gel column chromatography to prepare the object 12 in an amount of 1.47 g in a yield of 88 mol%.

### [Synthetic Example 7] Synthesis of Polymerizable compound 7

The synthesis of the compound 7 is described with reference to the schema 5.
To a 100 mL 2-necked flask, 1.94 g (5 mmol) of the object 11, 0.89 g (6 mmol) of styryl boric acid, 6.91 g (50 mmol) of potassium carbonate, 0.61 g (3 mmol) of tetrabutyl ammonium bromide, 50 mg of ditertialbutyl cresol, 40 mL of toluene and 25 mL of water were fed and stirred under reflux in nitrogen for 1 hr. To this solution, 231 mg (0.2 mmol) of tetrakis(triphenylphosphine)palladium (O) was added and stirred under reflux in nitrogen for 1 hr. After cooling, ethyl acetate and water were added and an organic layer was washed with water and saturated brine successively. The organic layer was concentrated, and a residue was eluted with hexane and chloroform in the proportion of 60 : 40 by silica gel column chromatography to prepare the object 13 (polymerizable compound 7) in an amount of 1.66 g in a yield of 81 mol%.

### [Synthetic Example 8] Synthesis of Polymerizable compound 8

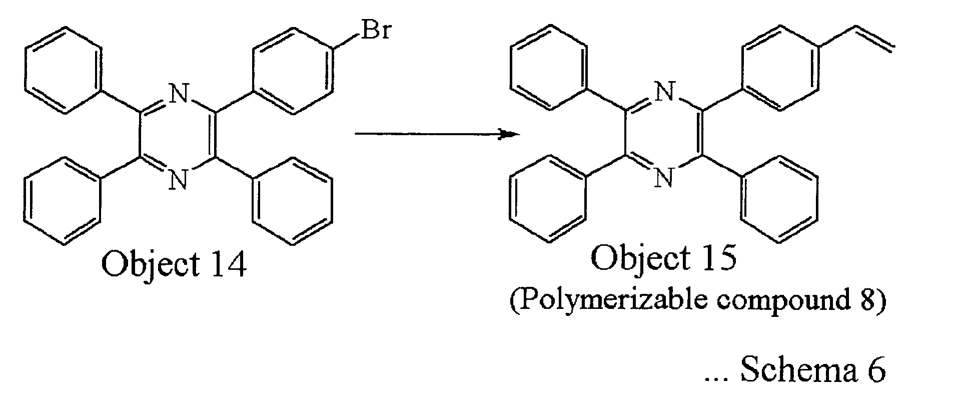

The synthesis of the compound 8 is described with reference to the schema 6.
The object 14 was synthesized by the method as described in JP-A-2007-197426.
To a 100 mL 2-necked flask, 1.39 g (3.00 mmol) of the object 14, 0.67 g (3.60 mmol) of vinyl boric acid dibutyl ester, 4.15 g (30.0 mmol) of potassium carbonate, 0.58 g (1.80 mmol) of tetrabutyl ammonium bromide, 40 mg of ditertialbutyl cresol, 25 mL of toluene and 15 mL of water were fed and stirred under reflux in nitrogen for 1 hr. To this solution, 104 mg (0.09 mmol) of tetrakis(triphenylphosphine)palladium (O) was added and stirred under reflux in nitrogen for 1 hr. After being left for cooling, ethyl acetate and water were added and an organic layer was washed with water and saturated brine successively. The organic layer was concentrated, and a residue was eluted with hexane and chloroform in the proportion of 65 : 35 by silica gel column chromatography to prepare the object 15 (polymerizable compound 8) in an amount of 0.81 g in a yield of 66 mol%.

### [Synthetic Example 9] Synthesis of Polymerizable compound 9

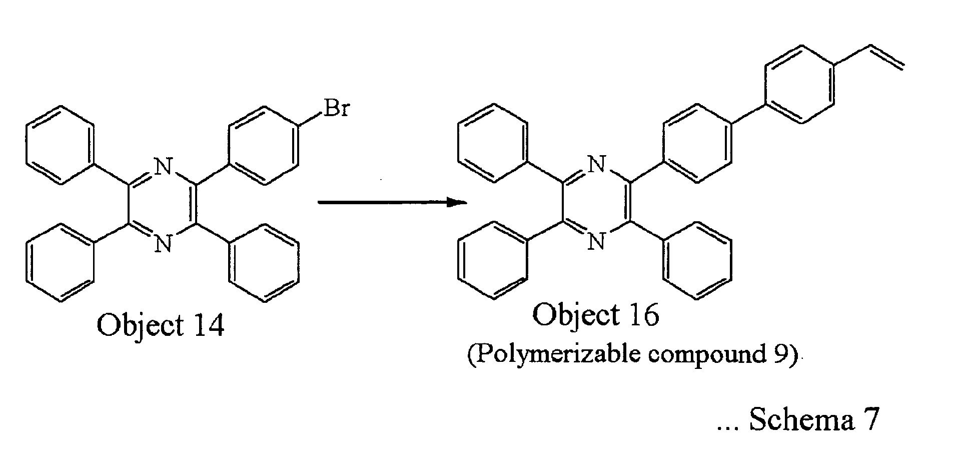

The synthesis of the compound 9 is described with reference to the schema 7.
To a 100 mL 2-necked flask, 1.39 g (3.00 mmol) of the object 14, 0.53 g (3.60 mmol) of styryl boric acid, 4.15 g (30.0 mmol) of potassium carbonate, 0.58 g (1.80 mmol) of tetrabutyl ammonium bromide, 40 mg of ditertialbutyl cresol, 25 mL of toluene and 15 mL of water were fed and stirred under reflux in nitrogen for 1 hr. To this solution, 104 mg (0.09 mmol) of tetrakis(triphenylphosphine)palladium (O) was added and stirred under reflux in nitrogen for 1 hr. After cooling, ethyl acetate and water were added and an organic layer was washed with water and saturated brine successively. The organic layer was concentrated, and a residue was eluted with hexane and chloroform in the proportion of 65 : 35 by silica gel column chromatography to prepare the object 16 (polymerizable compound 9) in an amount of 1.29 g in a yield of 80 mol%.

### [Synthetic Example 10] Synthesis of Homopolymer 1

To a sealing vessel, the polymerizable compound 1 (333 mg) was fed and dehydrated toluene (10 mL) was added, and then a toluene solution of a radical polymerization initiator V-601 manufactured by Wako Pure Chemical Industries Ltd. (0.1 M, 100 µL) was added and freeze-deaeration procedure was repeated five times. The vessel was sealed in vacuo and stirring was carried out at 60°C for 60 hr. After the reaction, the reacted solution was dropped into acetone (250 mL) to prepare a precipitate. Furthermore, the precipitate was purified by repeating the precipitation-purification with toluene-acetone twice. Thereafter the resulting precipitate was dried at 50°C in vacuo over night to prepare the homopolymer 1 (300 mg) as a white solid. The resulting copolymer had a weight average molecular weight (Mw), as measured by GPC in terms of polystyrene, of 42,000.

Similar to the above manner, homopolymers 2 to 9 were prepared. The weight average molecular weight of each polymer is shown below.
Homopolymer 2 (Polymerization of Polymerizable compound 2)
   (Mw) 58,000
Homopolymer 3 (Polymerization of Polymerizable compound 3)
   (Mw) 39,000
Homopolymer 4 (Polymerization of Polymerizable compound 4)
   (Mw) 41,000
Homopolymer 5 (Polymerization of Polymerizable compound 5)
   (Mw) 40,000
Homopolymer 6 (Polymerization of Polymerizable compound 6)
   (Mw) 51,000
Homopolymer 7 (Polymerization of Polymerizable compound 7)
   (Mw) 44,000
Homopolymer 8 (Polymerization of Polymerizable compound 8)
   (Mw) 43,000
Homopolymer 9 (Polymerization of Polymerizable compound 9)
   (Mw) 47,000

### [Synthetic Example 11] Synthesis of Homopolymer 10

To a sealing vessel, viPBD represented by the following formula (16) (350 mg) was fed and dehydrated toluene (10 mL) was added, and then a toluene solution of a radical polymerization initiator V-601manufactured by Wako Pure Chemical Industries Ltd. (0.1 M, 100 µL) was added and freeze-deaeration procedure thereof was repeated five times. The vessel was sealed in vacuo and stirring was carried out at 60°C for 60 hr. After the reaction, the reacted solution was dropped into acetone (250 mL) to prepare a precipitate. Furthermore, the precipitate was purified by repeating precipitation-purification with toluene-acetone twice.
Thereafter the resulting precipitate was dried at 50°C in vacuo over night to prepare the homopolymer 10 (300 mg) as a white solid. The resulting copolymer has a weight average molecular weight (Mw), as measured by GPC in terms of polystyrene, of 67,000.

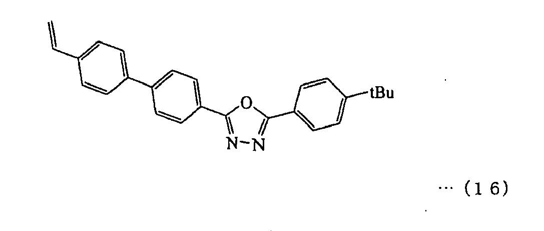

### [Synthetic Example 12] Synthesis of Copolymer 1

To a sealing vessel, the polymerizable compound 1 (300 mg) and a light-emitting polymerizable compound 10 represented by the following formula (79 mg) were fed and dehydrated toluene (8 mL) was added, and then a toluene solution of a radical polymerization initiator V-601 manufactured by Wako Pure Chemical Industries Ltd. (0.1 M, 100 µL) was added and freeze-deaeration procedure was repeated five times. The vessel was sealed in vacuo and stirring was carried out at 60°C for 60 hr. After the reaction, the reacted solution was dropped into acetone (250 mL) to prepare a precipitate. Furthermore, the resulting precipitate was purified by repeating precipitation-purification with toluene-acetone twice. Thereafter the reactant was dried at 50°C in vacuo over night to prepare the copolymer 1 (341 mg) as a pale yellow solid. The resulting copolymer 1 had a weight average molecular weight (Mw) measured by GPC in terms of polystyrene of 70,000. The copolymer 1 had a copolymerization ratio (molar ratio), as determined by NMR measurement, of polymerizable compound 1 to polymerizable compound 10 of 91/9.

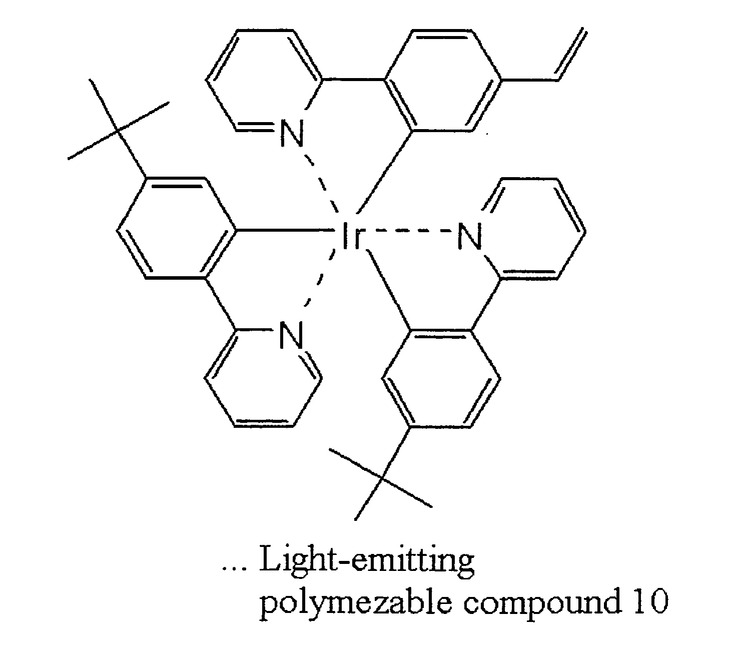

Similar to the above manner, copolymers 2 to 9 were prepared. The weight average molecular weight of each polymer is shown below.
Copolymer 2 (Polymerization of Polymerizable compounds 2
   and 10) (Mw) 68,000
Copolymer 3 (Polymerization of Polymerizable compounds 3
   and 10) (Mw) 71,000
Copolymer 4 (Polymerization of Polymerizable compounds 4 and 10) (Mw) 82,000
Copolymer 5 (Polymerization of Polymerizable compounds 5 and 10) (Mw) 59,000
Copolymer 6 (Polymerization of Polymerizable compounds 6 and 10) (Mw) 58,000
Copolymer 7 (Polymerization of Polymerizable compounds 7 and 10) (Mw) 63,000
Copolymer 8 (Polymerization of Polymerizable compounds 8 and 10) (Mw) 64,000
Copolymer 9 (Polymerization of Polymerizable compounds 9 and 10) (Mw) 67,000

### [Synthetic Example 13] Synthesis of Copolymer 10

To a sealing vessel, the polymerizable compound 1 (150 mg), the light-emitting polymerizable compound 10 (79 mg) and a polymerizable compound 15-4 represented by the following formula (15-4) (269 mg) were fed and dehydrated toluene (8 mL) was added, and then a toluene solution of a radical polymerization initiator V-601 manufactured by Wako Pure Chemical Industries Ltd. (0.1 M, 100 µL) was added and freeze-deaeration procedure thereof was repeated five times. The vessel was sealed in vacuo and stirring was carried out at 60°C for 60 hr. After the reaction, the reacted solution was dropped into acetone (250 mL) to prepare a precipitate. Furthermore, the resulting precipitate was purified by repeating precipitation-purification with toluene-acetone twice. Thereafter the precipitate was dried at 50°C in vacuo over night to prepare the copolymer 10 (448 mg) as a pale yellow solid. The resulting copolymer 10 had a weight average molecular weight (Mw), as measured by GPC in terms of polystyrene, of 67,000. The copolymer 10 had a copolymerization ratio (molar ratio), as determined by NMR measurement, of polymerizable compound 1, polymerizable compound 10 and polymerizable compound 15-4 of 47/44/9.

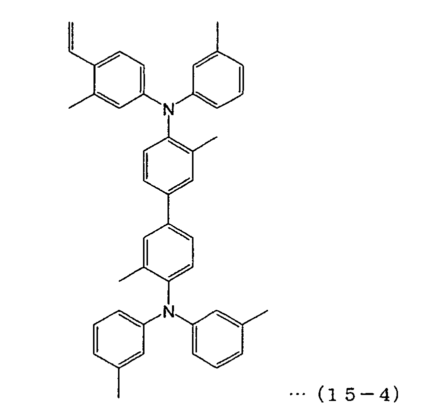

Similar to the above manner, copolymers 11 to 18 were prepared. The weight average molecular weight of each polymer is shown below.
Copolymer 11 (Polymerization of Polymerizable compounds 2,
   10 and 15-4) (Mw) 64,000
Copolymer 12 (Polymerization of Polymerizable compounds 3,
   10 and 15-4) (Mw) 70,000
Copolymer 13 (Polymerization of Polymerizable compounds 4,
   10 and 15-4) (Mw) 78,000
Copolymer 14 (Polymerization of Polymerizable compounds 5,
   10 and 15-4) (Mw) 62,000
Copolymer 15 (Polymerization of Polymerizable compounds 6,
   10 and 15-4) (Mw) 72,000
Copolymer 16 (Polymerization of Polymerizable compounds 7,
   10 and 15-4) (Mw) 69,000
Copolymer 17 (Polymerization of Polymerizable compounds 8,
   10 and 15-4) (Mw) 66,000
Copolymer 18 (Polymerization of Polymerizable compounds 9,
   10 and 15-4) (Mw) 66,000

### [Synthetic Example 14] Synthesis of Copolymer 19

The polymerization procedure of Synthetic Example 12 was repeated except for using viPBD (315 mg) in place of the polymerizable compound 1. The resulting copolymer 19 had a weight average molecular weight (Mw), as measured by GPC in terms of polystyrene, of 68,400. The copolymer 19 had a copolymerization ratio (molar ratio) of viPBD to polymerizable compound 10 of 91/9.

### [Synthetic Example 15] Synthesis of Copolymer 20

The polymerization procedure of Synthetic Example 13 was repeated except for using viPBD (157 mg) in place of the polymerizable compound 1. The resulting copolymer 20 had a weight average molecular weight (Mw), as measured by GPC in terms of polystyrene, of 56,000. The copolymer 20 had a copolymerization ratio (molar ratio) polymerizable compound 10 and polymerizable compound 15-4 of 47/44/9.

### [Example 1] Preparation of Organic EL element 1 and Measurement of Luminance thereof

Using a substrate equipped with ITO that on one surface of a glass substrate having a size of 25 mm x 25 mm, two ITO (tin indium oxide) electrodes having a width of 4 mm are formed in a striped state as an anode (manufactured by Nippo Electric Co., LTD.), an organic EL element 1 was prepared.

Firstly, on the ITO (anode electrode) of the substrate equipped with ITO, poly(3,4-ethylene dioxane thiophene) polystyrene sulfonic acid (Trade Name "Baytron P" manufactured by Bayer Co., Ltd.) was applied by a spin coating method at a rotation number of 3500 rpm for a coating time of 40 sec, and thereafter dried under reduced pressure at 60°C for 2 hr in a vacuum drying device to form an anode buffer layer. The anode buffer layer had a film thickness of about 50 nm.

Next, a coating solution was prepared for forming a layer, which comprises a light-emitting compound and a carrier-transporting compound. The homopolymer 1 (45 mg), 4,4',4"-tris(carbazole-9-yl)triphenylamine (TCTA) (45 mg) and an iridium complex E-2 represented by the following formula (E-2) (10 mg) was dissolved in toluene (manufactured by Wako Pure Chemical Industries Ltd., Special grade) (2910 mg) and the resulting solution was filtered off with a filter having a hole diameter of 0.2 µm to prepare the coating solution. Subsequently, the coating solution thus prepared was applied on the anode buffer layer by a spin coating method at a rotation number of 3000 rpm for a coating time of 30 sec, and thereafter dried at room temperature (25°C) for 30 min to form a light-emitting layer. The light-emitting layer had a film thickness of about 100 nm.

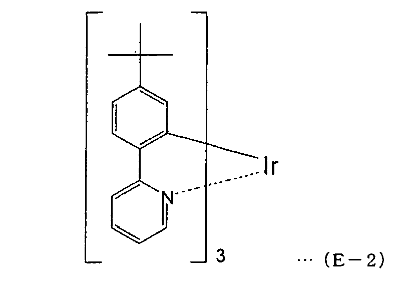

In the next step, the substrate having the light-emitting layer formed was placed in a vapor deposition device and cesium was vapor deposited at a vapor deposition rate of 0.01 nm/s to have a thickness of 2 nm (an alkali metal dispenser manufactured by SAES Getters was used as a cesium source) and successively, aluminum was vapor deposited at a vapor deposition rate of 1 nm/s as a cathode to have a thickness of 250 nm. The cesium and aluminum layers were formed in two strips having a width of 3 mm perpendicular to the extended direction of the anode. Per one glass substrate, four organic EL elements 1 having a length of 4 mm x a width of 3 mm were prepared.

The organic EL element was allowed to emit light by applying a voltage using a programmable direct current voltage/ current source TR6143 manufactured by ADVANTEST Corporation and the luminance was measured using a luminance measuring instrument BM-8 manufactured by TOPCON Corporation. In results, the light-emitting initiation voltage, the maximum luminance and the external quantum efficiency in lighting at 100 cd/m² are shown in Table 2. Each value was determined by averaging the values of four organic EL elements 1.

### [Examples 2 to 21] Preparation of Organic EL elements 2 to 21 and Measurement of Luminance thereof

In Examples 2 to 21, organic EL elements 2 to 21 were prepared using light-emitting materials and other materials as shown in Table 1 in the same manner as that of the organic EL element 1, and the luminance of each element was measured. In results, the light-emitting initiation voltage, the maximum luminance and the external quantum efficiency in lighting at 100 cd/m² are shown in Table 2.

### [Comparative Examples 1 to 3] Preparation of Organic EL elements 22 to 24 and Measurement of Luminance thereof

In Comparative Examples 1 to 3, organic EL elements 22 to 24 were prepared using light-emitting materials and other materials as shown in Table 1 in the same manner as that of the organic EL element 1, and the luminance of each element was measured. In results, the light-emitting initiation voltage, the maximum luminance and the external quantum efficiency in lighting at 100 cd/m² are shown in Table 2.

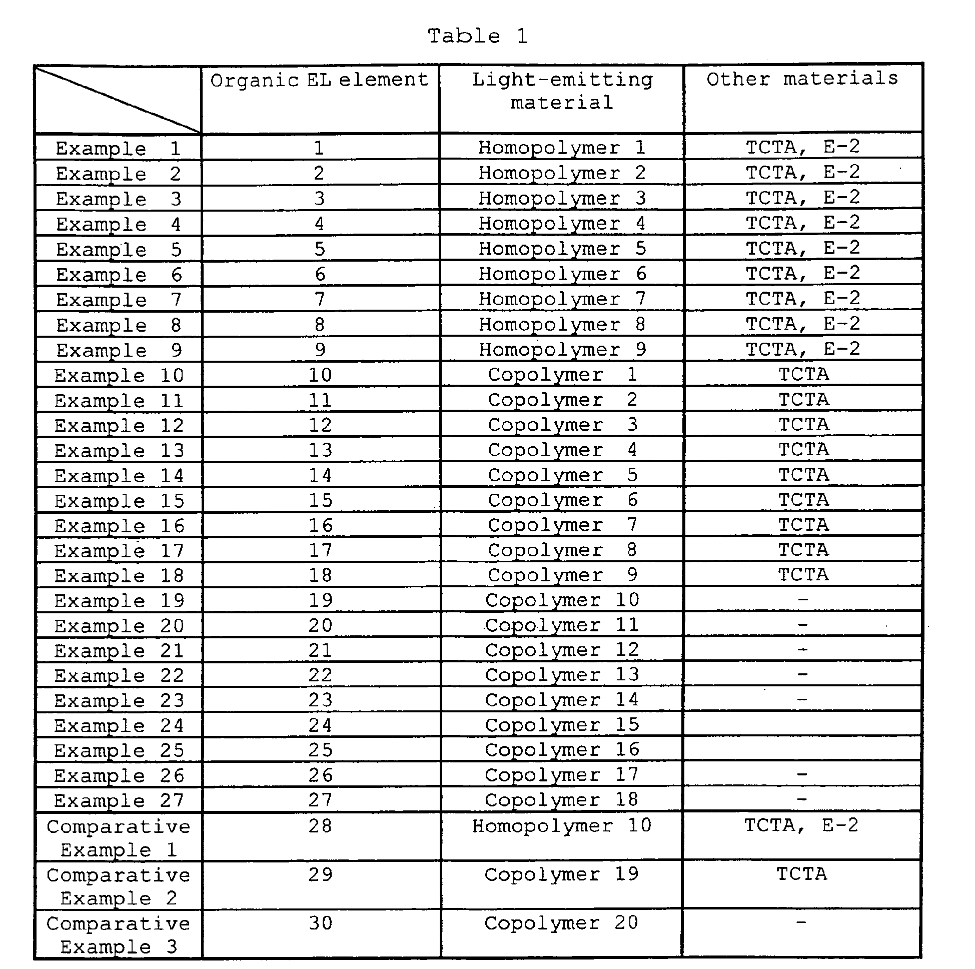

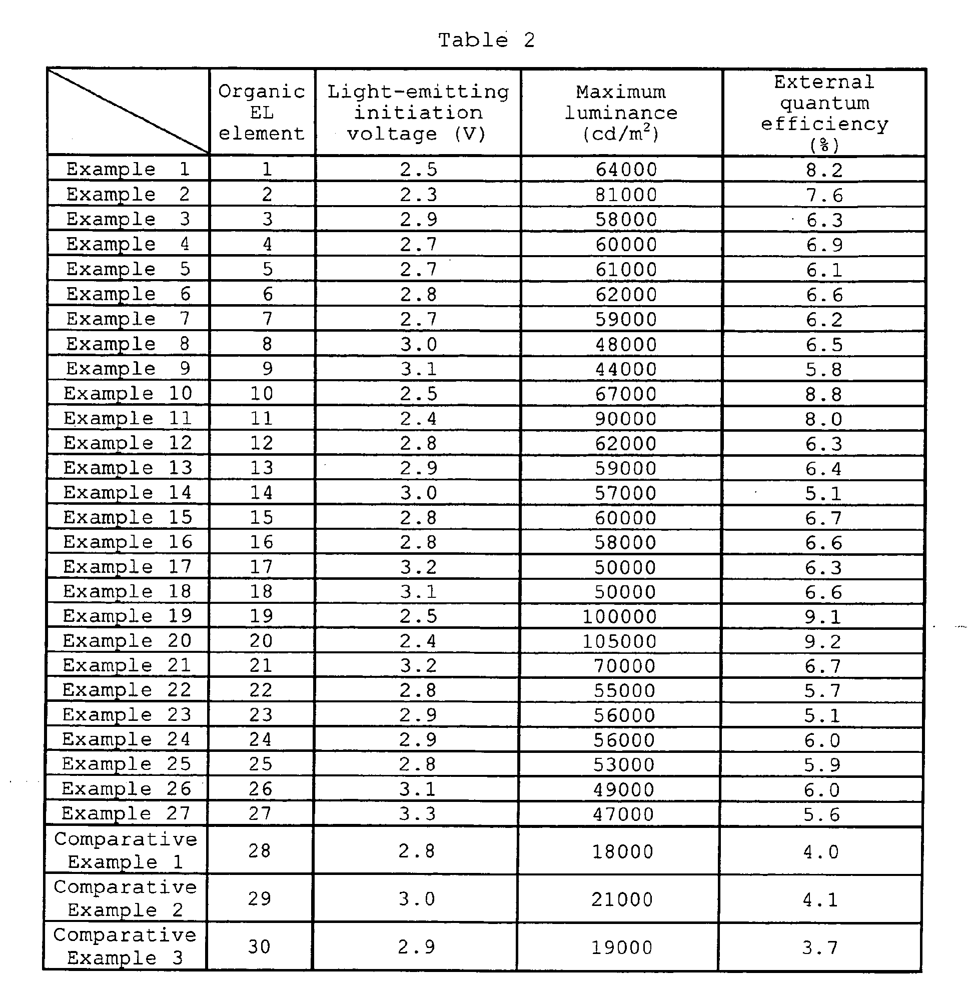

As is clear from Table 2, the organic EL elements 1 to 21 prepared using the polymer compound of the present invention in the electron-transporting site (Examples 1 to 21) have higher maximum luminance and better external quantum efficiency as compared with the organic EL elements 22 to 24 prepared using viPBD in the electron-transporting site (Comparative examples 1 to 3).

### Description of Number

1: Glass substrate
2: Anode
3: Positive hole-transporting layer
4: Light-emitting layer
5: Electron-transporting layer
6: Cathode

## Claims

1. A charge-transporting polymer compound comprising a constituting unit derived from at least one polymerizable compound selected from the group consisting of a polymerizable compound represented by the following formula (1), a polymerizable compound represented by the following formula (2) and a polymerizable compound represented by the following formula (3); 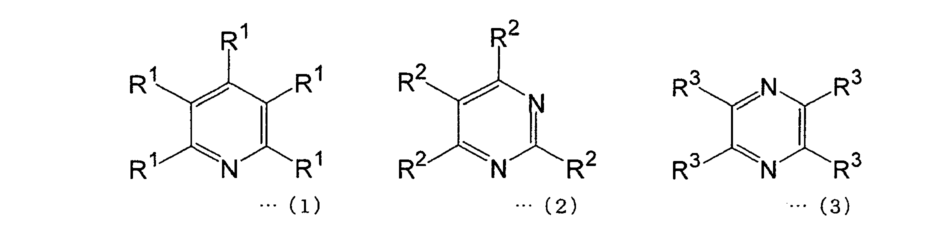 (in the formulas, R¹ to R³ are each independently hydrogen atom or an aromatic group optionally having a heteroatom as a ring-constituting atom;
provided that at least one R¹, at least one R² and at least one R³ each represent an aromatic group having a substituent with a polymerizable functional group and optionally having a heteroatom as a ring-constituting atom).

2. The charge-transporting polymer compound according to claim 1, wherein the polymerizable compound of the formula (1) is a polymerizable compound represented by the following formula (4),
the polymerizable compound of the formula (2) is a polymerizable compound represented by the following formula (5) and
the polymerizable compound of the formula (3) is a polymerizable compound represented by the following formula (6); 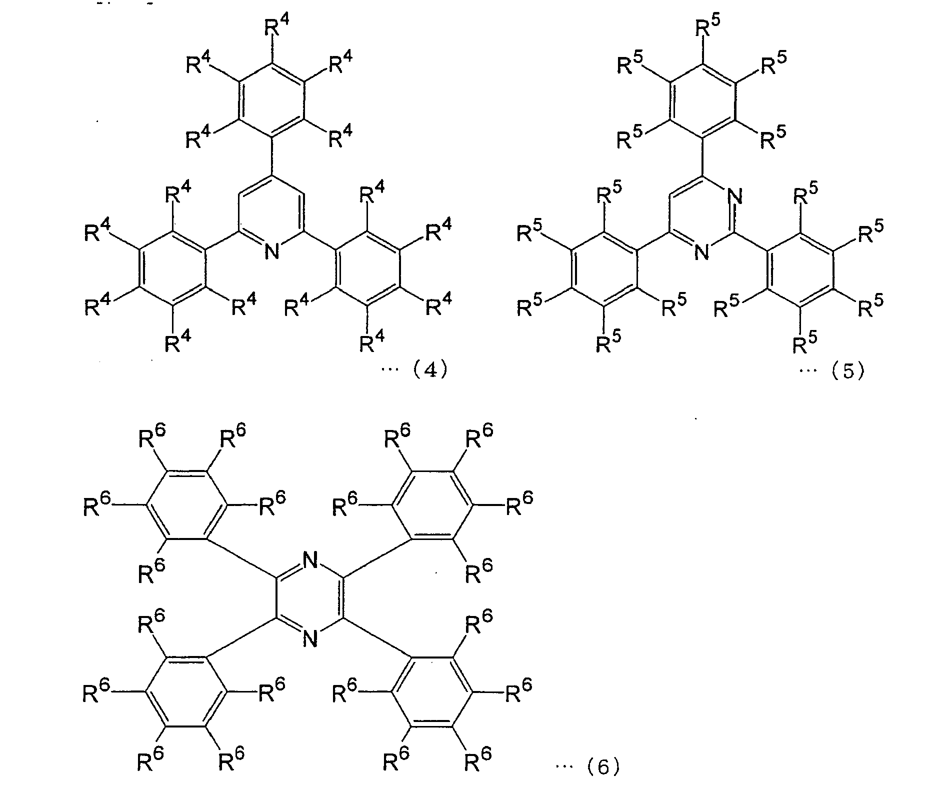 (in the formulas, R⁴ to R⁶ are each independently hydrogen atom, a halogen atom, an alkyl group having 1 to 12 carbon atoms or an aromatic group optionally having a heteroatom as a ring-constituting atom;
provided that at least one R⁴, at least one R⁵ and at least one R⁶ each represent an aromatic group having a substituent with a polymerizable functional group and optionally having a heteroatom as a ring-constituting atom).

3. The charge-transporting polymer compound according to claim 2, wherein the polymerizable compound of the formula (4) is a polymerizable compound represented by any one of the following formulas (1-1) to (1-16),
the polymerizable compound of the formula (5) is a polymerizable compound represented by any one of the following formulas (2-1) to (2-26) and
the polymerizable compound of the formula (6) is a polymerizable compound represented by any one of the following formulas (3-1) to (3-7); 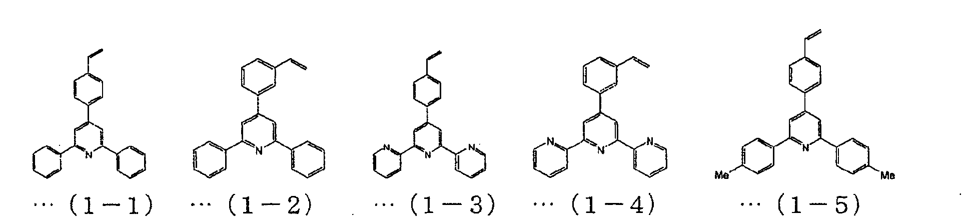 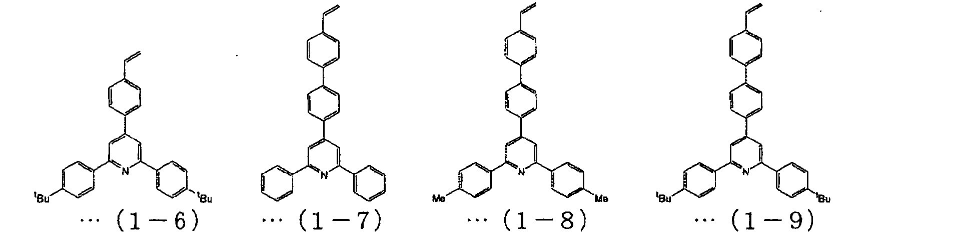 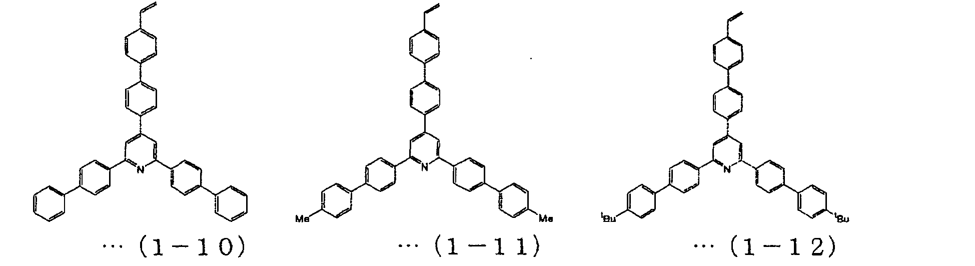 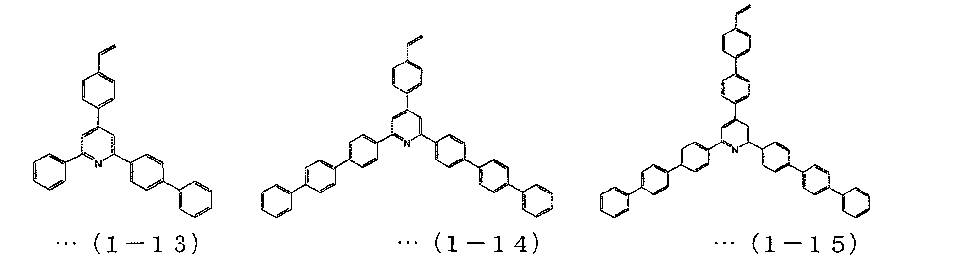 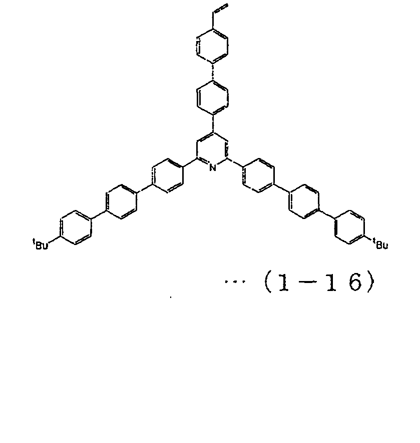 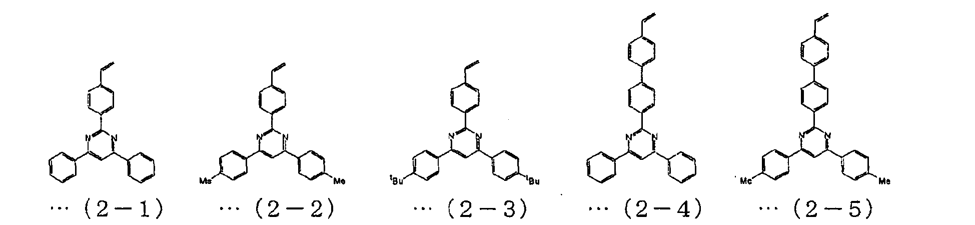 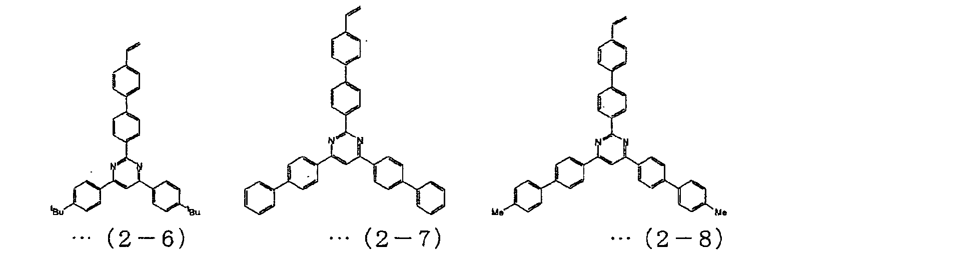 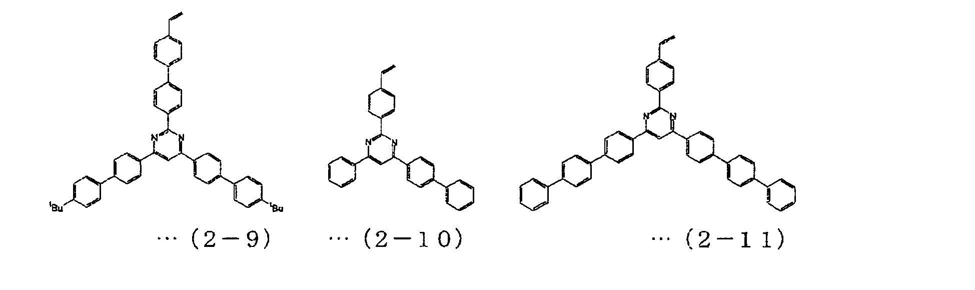 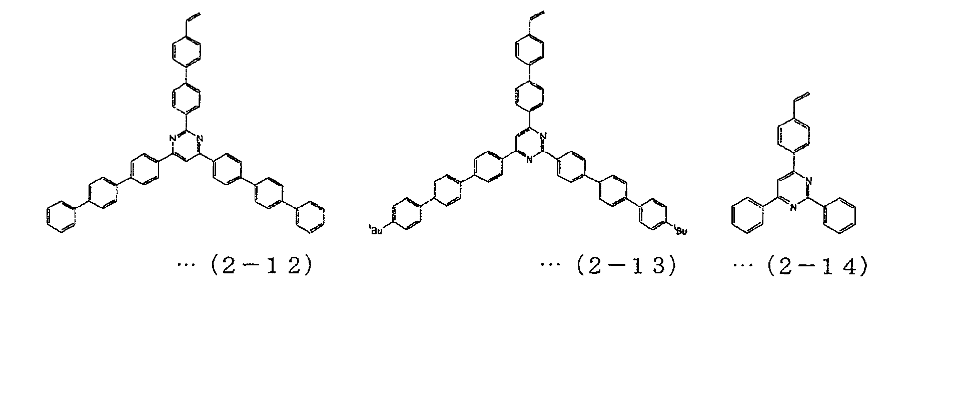 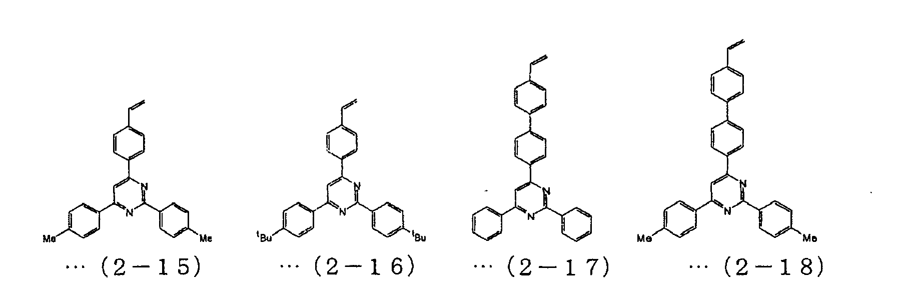 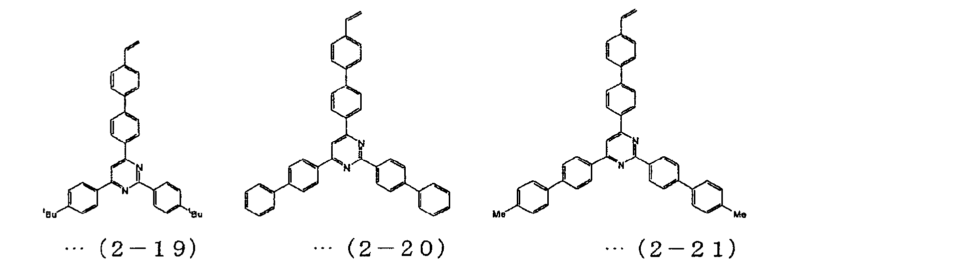 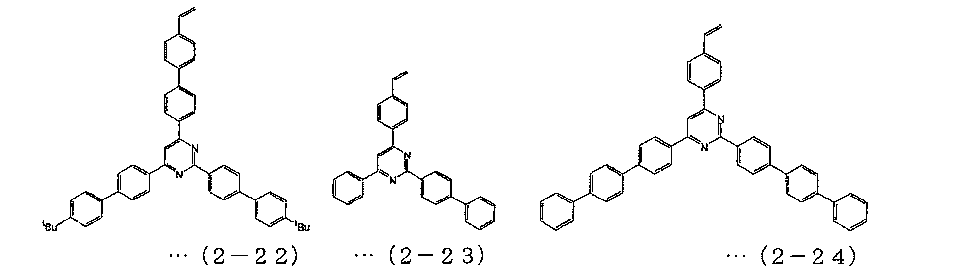 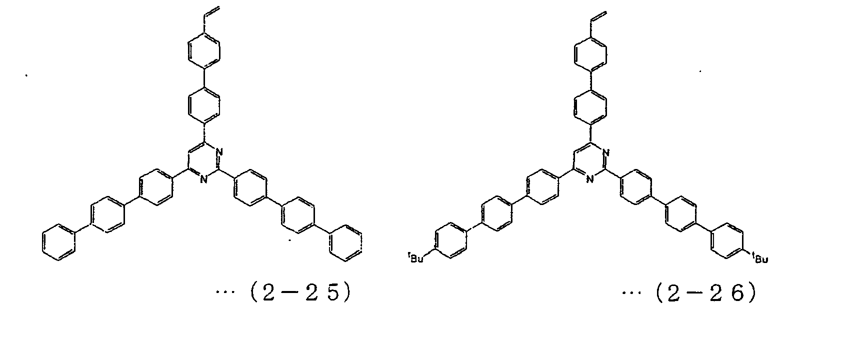 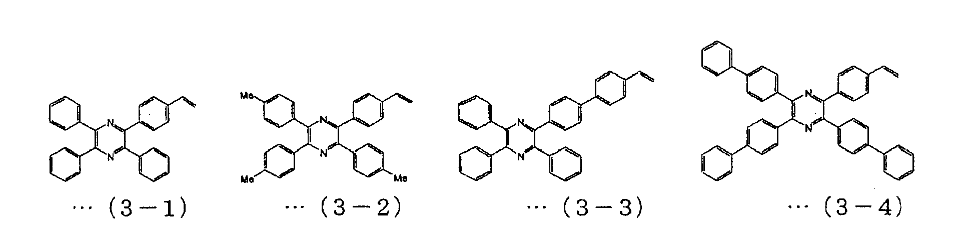 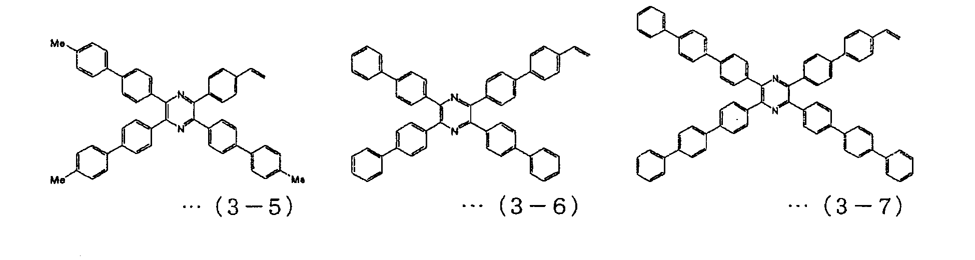 (in the formulas, "Me" is a methyl group and "^{t}Bu" is a t-butyl group).

4. The charge-transporting polymer compound according to any one of claims 1 to 3, which further comprises a constituting unit derived from a light-emitting polymerizable compound.

5. The charge-transporting polymer compound according to claim 4, wherein the light-emitting polymerizable compound has phosphorescent properties.

6. The charge-transporting polymer compound according to claim 5, wherein the light-emitting polymerizable compound is a transition metal complex having a substituent with a polymerizable functional group.

7. The charge-transporting polymer compound according to claim 6, wherein the transition metal complex is an iridium complex.

8. The charge-transporting polymer compound according to any one of claims 1 to 7, which further comprises a unit derived from a polymerizable compound having positive hole-transporting properties.

9. An organic electroluminescence element formed with a light-emitting layer between an anode and a cathode, wherein the light-emitting layer comprises the charge-transporting polymer compound according to any one of claims 1 to 8.
